# EUROPEAN PATENT SPECIFICATION

(11) **EP 4 593 566 B1**
(45) Date of publication and mention of the grant of the patent: **18.11.2026**
(21) Application number: 25153832.8
(22) Date of filing: 24.01.2025
(51) Int. Cl.: H10K 50/16, H10K 50/115

(54) **ELECTROLUMINESCENT DIODE, AND DISPLAY DEVICE INCLUDING SAME**
ELEKTROLUMINESZENZDIODE UND ANZEIGEVORRICHTUNG DAMIT
DIODE ÉLECTROLUMINESCENTE ET DISPOSITIF D'AFFICHAGE LA COMPRENANT

(30) Priority: 25.01.2024 KR 20240011773
(43) Date of publication of application: 30.07.2025
(73) Proprietor: Samsung Electronics Co., Ltd., Suwon-si, Gyeonggi-do 16677 (KR); Samsung Display Co., Ltd., Yongin-si, Gyeonggi-do 17113 (KR)
(72) Inventor: HWANG, Sungwoo, 16678 Suwon-si (KR); KIM, Sungwoo, 16678 Suwon-si (KR); CHUNG, You Jung, 16678 Suwon-si (KR); PARK, Sujin, 16678 Suwon-si (KR); YOO, Jun-Mo, 16678 Suwon-si (KR); LEE, Ilyoung, 16678 Suwon-si (KR); CHA, Soonmin, 16678 Suwon-si (KR)
(74) Representative: Elkington and Fife LLP

(56) References cited:
- YUN KU JUNG ET AL: "83-1: Improved performance of EL-QD display through surface modified QDs and inorganic nanoink", SID SYMPOSIUM DIGEST OF TECHNICAL PAPERS, WILEY-BLACKWELL PUBLISHING, INC, US, vol. 54, no. 1, 30 August 2023 (2023-08-30), pages 1162 - 1165, XP072822821, ISSN: 0097-966X, DOI: 10.1002/SDTP.16781
- RAJA A ET AL: "Wool roving textured reduced graphene oxide-HoVO4-ZnO nanocomposite for photocatalytic and supercapacitor performance", ELECTROCHIMICA ACTA, ELSEVIER, AMSTERDAM, NL, vol. 328, 12 October 2019 (2019-10-12), XP085898469, ISSN: 0013-4686, [retrieved on 20191012], DOI: 10.1016/J.ELECTACTA.2019.135062
- YOON SUK-YOUNG ET AL: "Performance Enhancement of InP Quantum Dot Light-Emitting Diodes via a Surface-Functionalized ZnMgO Electron Transport Layer", vol. 7, no. 7, 8 June 2022 (2022-06-08), American Chemical Society, pages 2247 - 2255, XP093282008, ISSN: 2380-8195, Retrieved from the Internet <URL:https://pubs.acs.org/doi/pdf/10.1021/acsenergylett.2c01065> DOI: 10.1021/acsenergylett.2c01065

## Description

### FIELD OF THE INVENTION

The present disclosure relates to surface-modified zinc-containing oxide nanoparticles, and electroluminescent diodes and display devices including the nanoparticles.

### BACKGROUND OF THE INVENTION

Semiconductor nanoparticles (e.g., semiconductor nanocrystal particles) having a nanometer size may emit light. For example, quantum dots including semiconductor nanocrystals may exhibit a quantum confinement effect. For example, light emission from the semiconductor nanoparticles may occur when an electron in an excited state resulting from light excitation or an applied voltage transits from a conduction band to a valence band. The semiconductor nanoparticles may be configured to emit light of a desired wavelength region by adjusting a size and/or composition of the semiconductor nanoparticles. Semiconductor nanoparticles may be used in a luminescent diode (e.g., electroluminescent diode) and a display device including the same.

Yun Ku Jung et al. in SID Symposium Digest of Technical Papers, vol. 54, no. 1, 30 August 2023, pages 1162-1165 discloses a ligand exchange procedure on the InP quantum dots and Zn(Mg)O nanoparticle surface to improve the efficiency at a quantum dot light emitting diode device.

Raja A et al. in Electrochimica Acta, vol. 328, 12 October 2019 discloses a rGO-HoVO₄-ZnO nanocomposite material comprising reduced graphene oxide (rGO), which is an excellent electron mediator, HoVO₄ and ZnO nanoparticle.

Yoon Suk-Young et al. in ACS Energy Letters, vol. 7, no. 7, 8 June 2022, pages 2247-2255 discloses a zinc-containing oxide nanoparticle comprising zinc and an additional metal other than zinc, and having an acrylate on a surface of the nanoparticle.

### SUMMARY OF THE INVENTION

Embodiments relate to a luminescent diode that includes semiconductor nanoparticles (e.g., quantum dots), that emit light with an applied voltage and a method for manufacturing the luminescent diode.

Embodiments relate to surface-modified zinc-containing oxide nanoparticles that can be used as an electron transport layer material of the luminescent diode, and to a method of manufacturing the zinc-containing oxide nanoparticles.

Embodiments may provide a display device (e.g., quantum dot light emitting diode (QD-LED) display) including a semiconductor nanoparticle (e.g., a quantum dot) as a light emitting material in one or more pixels, and the display device includes the aforementioned luminescent diode.

The zinc-containing oxide nanoparticles according to an embodiment include zinc, and an additional metal other than zinc, and include an oxo anion of vanadium (V) on a surface of the nanoparticles.

The additional metal may include an alkaline earth metal, zirconium (Zr), tungsten (W), titanium (Ti), yttrium (Y), aluminum (Al), gallium (Ga), indium (In), tin (Sn), cobalt (Co), vanadium (V), or a combination thereof.

The additional metal may include magnesium.

A molar ratio of zinc and the additional metal in the zinc-containing oxide nanoparticles may be about 99.9:0.1 to about 70:30.

The oxo anion of the vanadium may include one or more of those represented by the chemical formulas listed in Group 1:

(Group 1) VO₃⁻, VO₄³⁻, V₂O₇⁴⁻, V₃O₉³⁻, V₄O₁₂⁴⁻, V₅O₁₄³⁻, V₅O₁₅⁵⁻, V₆O₁₈⁶⁻, V₁₀O₂₈⁶⁻, V₁₂O₃₂⁴⁻, V₁₃O₃₄³⁻, V₁₈O₄₂¹²⁻, VO₂(OH)⁻₂, VO₃(OH)²⁻.

The zinc-containing oxide nanoparticles may have a particle size of greater than or equal to about 1 nanometer (nm) and less than or equal to about 30 nm.

According to another embodiment, a method of preparing a zinc-containing oxide nanoparticle that includes zinc, and an additional metal other than zinc, and includes an oxo anion of vanadium (V) on a surface of the nanoparticle, the method includes: dissolving a compound including an oxo anion of vanadium in a first organic solvent in which a basic compound is dissolved to obtain a first solution, dissolving a zinc precursor and a precursor of the additional metal other than zinc in a second organic solvent to obtain a second solution, and mixing the first solution with the second solution.

The additional metal may include an alkaline earth metal, zirconium (Zr), tungsten (W), titanium (Ti), yttrium (Y), aluminum (Al), gallium (Ga), indium (In), tin (Sn), cobalt (Co), vanadium (V), or a combination thereof.

The compound including an oxo anion of vanadium may be a salt including an oxo anion of vanadium and an alkali metal cation.

The oxo anion of vanadium may include one or more anions represented by the chemical formulas of Group 1:

(Group 1) VO₃⁻, VO₄³⁻, V₂O₇⁴⁻, V₃O₉³⁻, V₄O₁₂⁴⁻, V₅O₁₄³⁻, V₅O₁₅⁵⁻, V₆O₁₈⁶⁻, V₁₀O₂₈⁶⁻, V₁₂O₃₂⁴⁻, V₁₃O₃₄³⁻, V₁₈O₄₂¹²⁻, VO₂(OH)⁻₂, VO₃(OH)²⁻.

The basic compound may include an organic base that includes an organic group, an inorganic base that includes an alkali metal or alkaline earth metal, or a combination thereof.

The first organic solvent and the second organic solvent each independently may include a C1 to C10 alcohol solvent, dimethyl sulfoxide, a C3 to C15 hydrocarbon solvent, or a combination thereof, and the first organic solvent and the second organic solvent may be different solvents from each other.

The mixing of the first solution with the second solution may include heating and stirring the combined first solution and the second solution.

The method of preparing the zinc-containing oxide nanoparticles may include, after combining the first solution and the second solution, adding a third solvent that is not miscible with the first organic solvent and the second organic solvent to the reaction mixture (e.g., combined first and second solutions) to form a precipitate.

An electroluminescent diode according to another embodiment includes:
a first electrode and a second electrode that face each other,
a light emitting layer, including semiconductor nanoparticles, disposed between the first electrode and the second electrode, and
an electron transport layer between the light emitting layer and the second electrode,
wherein the electron transport layer includes zinc-containing oxide nanoparticles including zinc, an additional metal other than zinc, and an oxo anion of vanadium (V) on a surface of the nanoparticles.

The additional metal other than zinc may include an alkaline earth metal, zirconium (Zr), tungsten (W), titanium (Ti), yttrium (Y), aluminum (Al), gallium (Ga), indium (In), tin (Sn), cobalt (Co), vanadium (V), or a combination thereof.

The oxo anion of vanadium may include one or more vanadium-oxo anions represented by the chemical formulas of Group 1:

(Group 1) VO₃⁻, VO₄³⁻, V₂O₇⁴⁻, V₃O₉³⁻, V₄O₁₂⁴⁻, V₅O₁₄³⁻, V₅O₁₅⁵⁻, V₆O₁₈⁶⁻, V₁₀O₂₈⁶⁻, V₁₂O₃₂⁴⁻, V₁₃O₃₄³⁻, V₁₈O₄₂¹²⁻, VO₂(OH)⁻₂, VO₃(OH)²⁻.

An average particle size of the zinc-containing oxide nanoparticles in the electron transport layer may be greater than or equal to about 1 nm and less than or equal to about 30 nm.

A thickness of the electron transport layer may be greater than or equal to about 5 nm and less than or equal to about 60 nm.

The electroluminescent diode further may include a hole auxiliary layer between the first electrode and the light emitting layer.

A display device according to another embodiment includes the aforementioned electroluminescent diode.

According to an embodiment, the zinc-containing oxide nanoparticles that include zinc, and an additional metal other than zinc, and includes an oxo anion of vanadium on a surface thereof efficiently passivate defects in the zinc-containing oxide nanoparticles. Therefore, by introducing zinc-containing oxide nanoparticles into an electron transport layer of an electroluminescent diode that includes semiconductor nanoparticles in a light emitting layer, as described in an embodiment, an electroluminescent diode with improved external quantum efficiency and luminance and significantly increased life-span may be obtained.

### BRIEF DESCRIPTION OF THE DRAWINGS

FIG. 1 shows a schematic cross-sectional view of an electroluminescent diode according to an embodiment.
FIG. 2 shows a schematic cross-sectional view of an electroluminescent diode according to an embodiment.
FIG. 3 shows a schematic cross-sectional view of an electroluminescent diode according to an embodiment.
FIG. 4 is a schematic front view of a display panel according to an embodiment.
FIG. 5 is a schematic cross-sectional view of the display panel of FIG. 4 taken along line IV-IV.
FIG. 6 is a transmission electron microscopy (TEM) image of zinc oxide nanoparticles prepared in Preparation Example 1.
FIG. 7 is a graph showing X-ray Photoelectron Spectroscopy (XPS) analysis results of zinc magnesium oxide nanoparticles synthesized in Preparation Example 1 and Preparation Comparative Example 1.
FIG. 8 is a TEM-Energy Dispersive Spectroscopy (TEM-EDS) mapping image of zinc magnesium oxide nanoparticles having vanadate ions disposed on the surface, prepared in Preparation Example 1.
FIG. 9 is a graph showing TEM-EDS analysis results of FIG. 8.
FIG. 10 is a graph showing intensity (arbitrary unit, a.u.) versus wavelength (nanometers, nm) of an ultraviolet-visible (UV-Vis) absorption spectrum of the nanoparticles prepared in Preparation Example 1.
FIG. 11 is a graph showing intensity (a.u.) versus wavelength (nm) of an ultraviolet-visible (UV-Vis) absorption spectrum of the nanoparticles prepared in Preparation Example 2.
FIG. 12 is a graph showing intensity (a.u.) versus wavelength (nm) of an ultraviolet-visible (UV-Vis) absorption spectrum of the nanoparticles prepared in Preparation Example 3.
FIG. 13 is a schematic diagram showing the energy band arrangement for the diodes of Comparative Example 1, Example 2, and Example 4, calculated from Ultraviolet Photoelectron Spectroscopy (UPS) measurement results.

### DETAILED DESCRIPTION

Hereinafter, with reference to the accompanying drawings, various embodiments of the present disclosure will be described in detail so that those of ordinary skill in the art can easily carry out the present disclosure. The present disclosure may be embodied in many different forms and is not limited to the embodiments described herein.

In order to clearly explain the present disclosure, parts irrelevant to the description are omitted, and the same reference numerals are assigned to the same or similar elements throughout the specification.

The size and thickness of each constituent element as shown in the drawings are randomly indicated for better understanding and ease of description, and this disclosure is not necessarily limited to as shown. In the drawings, the thickness of layers, films, panels, regions, etc., are exaggerated for clarity. And in the drawings, for convenience of description, the thickness of some layers and regions are exaggerated.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" the reference portion means to be disposed above or below the reference portion, and does not necessarily mean "above" in an opposite direction of gravity.

In addition, unless explicitly described to the contrary, the word "comprise" and variations such as "comprises" or "comprising" will be understood to imply the inclusion of stated elements but not the exclusion of any other elements. It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein. The terminology used herein is for the purpose of describing particular embodiments only and is not intended to be limiting. As used herein, the singular forms "a," "an," and "the" are intended to include the plural forms, including "at least one," unless the content clearly indicates otherwise. Therefore, reference to "an" element in a claim followed by reference to "the" element is inclusive of one element as well as a plurality of the elements.

Further, the singular includes the plural unless mentioned otherwise. For example, the term particle may refer to a single particle or particles. Therefore, here, "zinc-containing oxide nanoparticle" may refer to one zinc-containing oxide nanoparticle or a plurality of zinc-containing oxide nanoparticles. Herein, "semiconductor nanoparticles" may refer to one semiconductor nanoparticle or multiple semiconductor nanoparticles.

Herein, "cross-section" may refer to a cross-section that is substantially vertically cut through the target portion when viewed from the side. Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein. Hereinafter, the value of the work function or HOMO or LUMO energy level is expressed as an absolute value from the vacuum level. In addition, when the work function or the energy level is referred to be "deep," "high" or "large," the work function or the energy level has a large absolute value based on "0 electron volt (eV)" of the vacuum level, while when the work function or the energy level is referred to be "shallow," "low," or "small," the work function or energy level has a small absolute value based on "0 eV" of the vacuum level.

As used herein, when a definition is not otherwise provided, "substituted" refers to replacement of at least one hydrogen of a compound or the corresponding moiety by a substituent of a C1 to C30 alkyl group, a C1 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group (-NO₂), a cyano group (-CN), an amino group (-NRR' wherein R and R' are independently hydrogen or a C1 to C6 alkyl group), an azido group (-N₃), an amidino group (-C(=NH)NH₂), a hydrazino group (-NHNH₂), a hydrazono group (=N(NH₂)), an aldehyde group (-C(=O)H), a carbamoyl group (-C(O)NH₂), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group (-SO₃H) or a salt thereof (-SO₃M, wherein M is an organic or inorganic cation), a phosphoric acid group (-PO₃H₂) or a salt thereof (-PO₃MH or -PO₃M₂, wherein M is an organic or inorganic cation), or a combination thereof. The specified number or range of carbon atoms in a compound or moiety is exclusive of any substituents.

Herein, the hydrocarbon group refers to a group consisting of carbon and hydrogen (e.g., an aliphatic group, such as, an alkyl, alkenyl, or alkynyl group, or an aromatic group such as an aryl group). The hydrocarbon group may be a group having a monovalence or more formed by removal of one or more hydrogen atoms of alkane, alkene, alkyne, or arene. In the hydrocarbon group, at least one methylene may be replaced by an oxide moiety (-O-), a carbonyl moiety (-(C=O)-), an ester moiety (-C(=O)=CO-), -NH-, or a combination thereof. Unless otherwise stated to the contrary, the hydrocarbon (alkyl, alkenyl, alkynyl, or aryl) group may have 1 to 60, 2 to 32, 3 to 24, 4 to 12, or 6 to 10 carbon atoms.

As used herein, "alkyl" refers to a linear or branched saturated monovalent hydrocarbon group (methyl, ethyl hexyl, etc.).

As used herein, "alkenyl" refers to a linear or branched monovalent hydrocarbon group having one or more carbon-carbon double bond.

As used herein, "alkynyl" refers to a linear or branched monovalent hydrocarbon group having one or more carbon-carbon triple bond.

As used herein, "aryl" refers to a group formed by removal of at least one hydrogen from an aromatic group (e.g., a phenyl or naphthyl group).

As used herein, "hetero" refers to one including 1 to 3 heteroatoms of **N,** O, S, Si, P, or a combination thereof.

As used herein, "alkoxy" means an alkyl group linked via an oxygen (i.e., alkyl-O-), such as a methoxy, ethoxy, or sec-butyloxy group.

An "amine group" may be -NRR, where, Rs are each independently hydrogen, a C1 to C12 alkyl group, a C7 to C20 alkylarylene group, a C7 to C20 arylalkylene group, or a C6 to C18 aryl group.

Herein, the description that it does not include cadmium (or other toxic heavy metal) may refer to a concentration of cadmium (or other heavy metals) of less than or equal to about 100 parts per million (ppm), less than or equal to about 50 ppm, less than or equal to about 10 ppm, or almost zero. In an embodiment, substantially no cadmium (or other heavy metals) is present, or, if present, in an amount below the detection limit of a given detection means or impurity level.

Unless otherwise stated, numerical ranges stated herein are inclusive.

Unless otherwise stated, the words "substantially" or "approximately" or "about" are omitted before values in the numerical ranges specified herein.

As used herein, "substantially" or "approximately" or "about" means not only the stated value, but also the mean within an acceptable range of deviations, considering the errors associated with the corresponding measurement and the measurement of the measured value. For example, "substantially" or "approximately" can mean within ± 5%, ± 3%, or ± 1% or within standard deviation of the stated value.

Herein, a nanostructure refers to a structure having a nanoscale dimension or a characteristic dimension in at least one direction. In an embodiment, the dimension of the nanoparticle may be less than about 300 nm, less than about 250 nm, less than about 150 nm, less than about 100 nm, less than about 50 nm, or less than about 30 nm. The nanostructures may have any shape. Unless otherwise specified herein, the nanoparticles or semiconductor nanoparticles may have any shape, such as a nanowire, a nanorod, a nanotube, a multi-pod type shape having two or more pods, a nanodot (or a quantum dot), or the like, but are not particularly limited. The nanoparticles may be, for example, substantially crystalline, substantially monocrystalline, polycrystalline, amorphous, or a combination thereof

For example, semiconductor nanoparticles such as quantum dots can exhibit quantum confinement or exciton confinement. In this specification, the terms nanoparticle or quantum dot are not limited in shape unless specifically defined. Semiconductor nanoparticles, such as quantum dots, can have a size smaller than the diameter of the Bohr diameter in a bulk crystal of the same material and can exhibit quantum confinement effects. Quantum dots can emit light corresponding to their band gap energy by controlling the size of the luminescent center of the nanocrystal.

Herein, the size or average size (hereinafter referred to as "size") of nanoparticles, such as quantum dots or zinc oxide nanoparticles, may be the particle diameter (or average diameter). The particle size of the nanoparticles may be an equivalent diameter obtained by a calculation involving conversion of a two-dimensional area confirmed by transmission electron microscopy analysis into a circle. The size of luminescent semiconductor nanoparticles, such as quantum dots, may be a nominal size that can be calculated from the composition of the semiconductor nanoparticles (e.g., the composition of the particles as determined by appropriate analytical means such as inductively coupled plasma atomic emission spectrometry (ICP-AES) and the emission peak wavelength.

Herein, T50 refers to the time taken for luminance of a given device to decrease to 50% based on 100% of the initial luminance, when the device is driven at predetermined initial luminance.

Herein, T90 refers to the time taken for luminance of a given device to decrease to 90% based on 100% of the initial luminance, when the device is driven at predetermined initial luminance.

Herein, the term "external quantum efficiency (EQE)" refers to a ratio of the number of photons emitted from a light emitting diode (LED) to the number of electrons passing through the device. EQE may be a measure of how efficiently the light emitting diode converts the electrons into the photons and allows them to escape. In an embodiment, EQE may be determined based on the following equation: 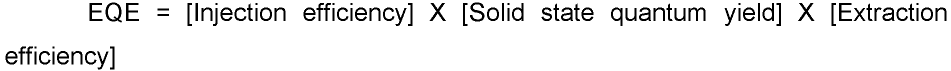 EQE = [Injection efficiency] X [Solid state quantum yield] X [Extraction efficiency]

Wherein, the Injection efficiency is a proportion of electrons passing through the device that are injected into the active region;
the solid state quantum yield is a proportion of all electron-hole recombinations in the active region that are radiative, and thus, produce photons; and
The extraction efficiency is a proportion of photons generated in the active region that escape from the device.

Herein, the maximum external quantum efficiency refers to a maximum value of the external quantum efficiency.

Herein, the maximum luminance refers to a maximum value of luminance that the device can achieve.

Herein, quantum efficiency is a term used interchangeably with quantum yield. Quantum efficiency (or quantum yield) may be measured either in solution or in the solid state (in a composite). In an embodiment, quantum efficiency (or quantum yield) is the ratio of photons emitted to photons absorbed by the nanostructure or population thereof. In an embodiment, quantum efficiency may be measured by any method. For example, for fluorescence quantum yield or efficiency, there may be two methods: an absolute method and a relative method.

In the absolute method, quantum efficiency is obtained by detecting the fluorescence of all samples through an integrating sphere. In the relative method, the quantum efficiency of the unknown sample is calculated by comparing the fluorescence intensity of a standard dye (standard sample) with the fluorescence intensity of the unknown sample. Coumarin 153, Coumarin 545, Rhodamine 101 inner salt, Anthracene, Rhodamine 6G, and the like, may be used as standard dyes according to their PL wavelengths, but the present disclosure is not limited thereto.

Herein, the emission peak wavelength refers to the wavelength at which the emission spectrum of light reaches its maximum value.

Herein, the full width at half maximum (FWHM) is defined as a difference between two variable values that is half the maximum value of a given peak.

The numerical ranges specified herein may or may not include the boundary values.

Energy band gaps of quantum dots may be changed according to sizes, structures, and compositions of nanocrystals. For example, as the sizes of the quantum dots increase, the semiconductor nanocrystals may have narrow energy band gaps and increased emission wavelengths. Semiconductor nanocrystals are attracting attention as light emitting materials in various fields such as display devices, energy devices, and bioluminescent diodes.

A semiconductor nanocrystal particle-containing luminescent diode (hereinafter referred to as QD-LED) that emits light when a voltage is applied includes a semiconductor nanocrystal particle as a light emitting material. QD-LED adopts a different emission principle from that of an organic light emitting diode (OLED) emitting light by using an organic material as an emission center but may realize colors of greater purity (red, green, or blue) and improved color reproducibility, and therefore, QD-LED has generated great interest as a next generation display device. Moreover, QD-LED may be produced at a reduced cost by using a solution process and may be expected to realize increased stability because a QD-LED is primarily based on an inorganic material. Accordingly, further development in such display technology for improving device properties and life-span characteristics is of ongoing interest. In addition, quantum dots having electroluminescence properties at a practically applicable level may include harmful heavy metals such as cadmium (Cd), lead, mercury, or a combination thereof. Therefore, it is desirable to provide a luminescent diode or display device having a light emitting layer including environmentally-friendly quantum dots that substantially do not include harmful heavy metals, for example, quantum dots that do not include cadmium.

Metal oxide nanoparticles, such as zinc oxide (ZnO) nanoparticles, are used as electron transport layer materials in QD-LED devices. Solution-containing processes such as sol-gel or solution-precipitation are being used to introduce these metal oxide nanoparticles into the electron transport layer of QD-LED devices. The colloidal particles of metal oxide formed in the synthetic process may include an organic substance derived from a precursor for forming the colloidal particles as a stabilizing ligand on the particle surface. However, nanoparticles prepared by the aforementioned bottom-up synthesis method may have their own surface defects, such as Zn interstitial (Znᵢ) and/or oxygen vacancy (V_{O}) defects, and depending on the degree of these defects, the efficiency of the electron transport layer within the device may reduce, or there may be a problem of device deterioration. The defects in zinc-containing oxide nanoparticles are known to be very diverse in type and form, and it is very difficult to control them in a desired direction.

In addition, although the Cd-quantum dot-containing LED structure including the metal oxide nanoparticles in the electron transport layer (ETL) shows high efficiency, in the Cd-free QD-LED structure, there is a problem in that the charge balance between holes moving through the hole transport layer (HTL) and electrons moving through the ETL including metal oxide nanoparticles, such as zinc-containing oxide nanoparticles, is not smoothly maintained. This results in a decrease in the efficiency of Cd-free QD-LEDs and also causes device deterioration due to charge imbalance. Accordingly, attempts have been reported to control the movement speed of holes or electrons by coating polymers such as polymethyl methacrylate (PMMA) within the LED structure to optimize charge balance; however, there are many limitations in applying this to commercial processes because the composition and content of the polymer, as well as the thickness of the layer formed, can affect the operation of the device.

There have also been attempts to control the particle size, distribution, amount of surface organic material, and degree of surface defect passivation by modifying the synthesis step of zinc-containing oxide nanoparticles or the final dispersion state of zinc-containing oxide nanoparticles before being applied to devices. The dispersion of zinc-containing oxide nanoparticles manufactured in this manner can be made into a thin film through a coating process and applied as an electron transport layer (ETL), so it has the advantage of being able to increase the characteristics of QD-LED without significant process restrictions. However, as mentioned above, it is very difficult to control the defects of zinc-containing oxide nanoparticles in a desired direction.

To address this, it has been reported that alkali metal carbonate is incorporated or blended to improve conductivity, electrical properties, band gap control, and thermal stability, thereby improving QD-LED performance. However, this is unfortunate in that it does not control the defects of the particles themselves, and thus there is a limit to the improvement of the device, and it is difficult to identify the exact mechanism because the device characteristics vary depending on the characteristics of the alkali metal.

The inventors hereof have confirmed that by introducing oxo anions of vanadium (V) to the surface of zinc-containing oxide nanoparticles, for example, zinc-containing oxide nanoparticles that include zinc, and an additional metal in addition to zinc, band gap of the nanoparticles may be expanded and minimum value of the conduction band (CBM: Conduction Band Minimum) may be upshifted, thereby lowering the electron conduction barrier from the electron transport layer to the light emitting layer including quantum dots to increase the conduction characteristics, and thus, significantly improving the performance and life-span of a quantum dot electroluminescent diode including the nanoparticles in an electron transport layer. Thus, zinc-containing oxide nanoparticles according to an embodiment may include zinc, and an additional metal other than zinc, and may include an oxo anion of vanadium on a surface thereof.

The additional metal other than zinc may include an alkaline earth metal, such as, for example, magnesium, calcium, beryllium, barium, strontium, or a combination thereof. Although not intended to be bound by a particular theory, it is thought that the presence of alkaline earth metals may contribute to suppressing exciton quenching in a quantum dot-containing light emitting layer and improving electron transport in a quantum dot-containing light emitting layer by reducing oxygen vacancies or defects within the electron transport layer. In an embodiment, the alkaline earth metal may include magnesium. The additional metal other than zinc may, optionally, further include, in addition to the alkaline earth metal, zirconium (Zr), tungsten (W), titanium (Ti), yttrium (Y), aluminum (Al), gallium (Ga), indium (In), tin (Sn), cobalt (Co), vanadium (V), or a combination thereof. The oxide nanoparticles may not or may further include an alkaline metal. The zn-containing oxide nanoparticles or the alkaline metal may further include sodium (Na), potassium (K), cesium (Cs), rubidium (Rb), francium (Fr), or a combination thereof. The zn-containing oxide nanoparticles or the alkaline metal may or may not include lithium (Li).

In an embodiment, the zinc-containing oxide nanoparticles may include Zn₁₋ₓ M¹ₓO (wherein M¹ is an alkaline earth metal, and optionally zirconium (Zr), tungsten (W), lithium (Li), titanium (Ti), yttrium (Y), aluminum (Al), gallium (Ga), indium (In), sodium (Na), potassium (K), cesium (Cs), tin (Sn), cobalt (Co), vanadium (V), or a combination thereof, and x is greater than 0 and less than or equal to 0.3). Herein, in the above chemical formula, x may be greater than or equal to about 0.01, greater than or equal to about 0.03, greater than or equal to about 0.05, greater than or equal to about 0.07, greater than or equal to about 0.1, greater than or equal to about 0.13, greater than or equal to about 0.15, greater than or equal to about 0.17, greater than or equal to about 0.18, greater than or equal to about 0.19, greater than or equal to about 0.2, greater than or equal to about 0.21, greater than or equal to about 0.22, greater than or equal to about 0.23, greater than or equal to about 0.25, greater than or equal to about 0.27, or greater than or equal to about 0.29. The x may be less than or equal to about 0.3, less than or equal to about 0.27, less than or equal to about 0.25, less than or equal to about 0.23, less than or equal to about 0.20, less than or equal to about 0.18, less than or equal to about 0.16, less than or equal to about 0.15, less than or equal to about 0.14, less than or equal to about 0.13, less than or equal to about 0.12, less than or equal to about 0.11, less than or equal to about 0.10, less than or equal to about 0.09, less than or equal to about 0.08, less than or equal to about 0.07, less than or equal to about 0.06, or less than or equal to about 0.05. That is, the mole ratio of zinc to the additional metal other than zinc in the zinc-containing oxide nanoparticles according to an embodiment may be about 99.9:0.01 to about 70:30, for example, about 99:1 to about 70:30, about 95:5 to about 70:30, about 90:10 to about 75:25, about 90:10 to about 80:20, or about 90:10 to about 85:15, but is not limited to these ranges.

According to an embodiment, the zinc-containing oxide nanoparticles may include oxo anions of vanadium on a surface thereof. The oxo anion of vanadium may also be commonly called as a 'vanadate', and 'oxo anion of vanadium' and 'vanadate' may be used interchangeably with the same meaning. The oxo anion of vanadium may include, for example, one or more of those represented by the chemical formulas shown in Group 1:

(Group 1) VO₃⁻, VO₄³⁻, V₂O₇⁴⁻, V₃O₉³⁻, V₄O₁₂⁴⁻, V₅O₁₄³⁻, V₅O₁₅⁵⁻, V₆O₁₈⁶⁻, V₁₀O₂₈⁶⁻, V₁₂O₃₂⁴⁻, V₁₃O₃₄³⁻, V₁₈O₄₂¹²⁻, VO₂(OH)⁻₂, VO₃(OH)²⁻.

In an embodiment, the oxo anions of vanadium may be VO₃⁻, VO₄³⁻, V₂O₇⁴⁻, V₃O₉³⁻, VO₃(OH)²⁻, or a combination thereof, but are not limited thereto.

A method of introducing a metal element, such as, for example, magnesium or vanadium, into the crystalline lattice of zinc oxide to widen the band gap energy of a zinc-containing oxide nanoparticle has been reported. However, the zinc-containing oxide nanoparticles according to an embodiment may not be nanoparticles in which a metal element is introduced into the crystalline lattice, but the nanoparticles including oxo anions of vanadium on a surface thereof, which were not known prior to the priority date of the present application.

The average particle size of the zinc-containing oxide nanoparticles according to an embodiment may be greater than or equal to about 1 nm and less than or equal to about 30 nm, for example, greater than or equal to about 1 nm, greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, greater than or equal to about 11 nm, greater than or equal to about 12 nm, greater than or equal to about 15 nm, greater than or equal to about 17 nm, greater than or equal to about 20 nm, greater than or equal to about 22 nm, greater than or equal to about 25 nm, or greater than or equal to about 27 nm, and less than or equal to about 30 nm, less than or equal to about 25 nm, less than or equal to about 23 nm, less than or equal to about 20 nm, less than or equal to about 18 nm, less than or equal to about 15 nm, less than or equal to about 13 nm, less than or equal to about 12 nm, less than or equal to about 10 nm, less than or equal to about 9 nm, less than or equal to about 8 nm, less than or equal to about 7 nm, less than or equal to about 6 nm, less than or equal to about 5 nm, less than or equal to about 4 nm, less than or equal to about 3 nm, less than or equal to about 2.5 nm, less than or equal to about 2 nm, or less than or equal to about 1 nm. For example, the average size of the zinc-containing oxide nanoparticles according to an embodiment may be, about 2 nm to about 20 nm, for example, about 3 nm to about 20 nm, about 3 nm to about 15 nm, or about 5 nm to about 10 nm, but is not limited thereto.

According to an embodiment, a method of preparing zinc-containing oxide nanoparticles that include zinc, and an additional metal other than zinc, and include an oxo anion of vanadium on a surface thereof may include dissolving a compound including an oxo anion of vanadium in a first organic solvent in which a basic compound is dissolved to obtain a first solution, dissolving a zinc precursor and a precursor of an additional metal other than zinc in a second organic solvent to obtain a second solution, and mixing and reacting the first solution and the second solution.

The basic compound may include a strongly basic compound having a pH of greater than or equal to about 8, for example, greater than or equal to about 8.5, greater than or equal to about 9, greater than or equal to about 9.5, greater than or equal to about 10, greater than or equal to about 10.5, or greater than or equal to about 11. For example, the basic compound may include an organic base including an organic group, an inorganic base including an alkali metal or alkaline earth metal, or a combination thereof.

For example, the organic base may include an organic base including an aliphatic hydrocarbon group having a C1 to C50 organic group, such as, for example, an alkyl group, and may be an organic base including one, two, three, or four substituted or unsubstituted aliphatic hydrocarbon groups (e.g., alkyl groups, alkenyl groups, or alkynyl groups) having carbon atoms in a range of, for example, C1-C50, C2-C40, C3-C30, C4-C25, C5-C20, C6-C15, C7-C14, C8-C12, C9-C11, or a combination thereof. The organic base may include a quaternary ammonium base, for example, a trialkyl ammonium hydroxide (e.g., trimethyl ammonium hydroxide, diethylmethyl ammonium hydroxide, dimethylethyl ammonium hydroxide, or a combination thereof).

For example, the inorganic base may include a hydroxide of an alkali metal (e.g., lithium hydroxide, sodium hydroxide, potassium hydroxide, cesium hydroxide, rubidium hydroxide, francium hydroxide, or a combination thereof). The inorganic base may include hydroxides of two or more alkali metals, for example, potassium hydroxide, cesium hydroxide, rubidium hydroxide, or a combination thereof, and may be used, for example, together with the organic base, or without the organic base. In an embodiment, when the basic compound includes an inorganic base, the resulting zinc-containing oxide nanoparticles may further include an alkali metal (e.g., lithium, sodium, potassium, rubidium, cesium, or a combination thereof).

The basic compound may be dissolved in the first organic solvent at a concentration of about 0.1 molar (M) to about 1 M. For example, the basic compound may be included in the first organic solvent at a concentration of about 0.1 M to about 0.8 M, about 0.1 M to about 0.7 M, about 0.2 M to about 0.8 M, about 0.2 M to about 0.7 M, about 0.3 M to about 0.8 M, about 0.3 M to about 0.7 M, about 0.3 M to about 0.6 M, about 0.4 M to about 0.8 M, about 0.4 M to about 0.7 M, or about 0.4 M to about 0.6 M, but is not limited to these ranges.

The compound including the oxo anions of vanadium may include a salt compound including a cation of an alkali metal or alkaline earth metal and the oxo anions of vanadium described in Group 1. For example, the compound including the oxo anions of vanadium may include a compound including a cation of lithium, sodium, potassium, rubidium, cesium, francium, magnesium, calcium, beryllium, strontium, barium, or a combination thereof. For example, the compound including the oxo anions of vanadium may include a cation of potassium, rubidium, cesium, or a combination thereof. For example, the compound including the oxo anions of vanadium may include potassium metavanadate, but is not limited thereto.

The compound including oxo anions of vanadium may be included in the mixture of the first solution and the second solution such that the oxo anions of vanadium separated therefrom is present on the surface of the zinc-containing oxide nanoparticles in an amount relative to the total moles of zinc in the zinc-containing oxide nanoparticles to be produced by the reaction, for example, less than or equal to about 30 moles based on 100 moles of zinc, for example, less than or equal to about 25 moles based on 100 moles of zinc, less than or equal to about 20 moles based on 100 moles of zinc, less than or equal to about 15 moles based on 100 moles of zinc, or less than or equal to about 10 moles based on 100 moles of zinc. For example, the oxo anions of vanadium may be included in the mixture of the first solution and the second solution so as to be present on the surface of the zinc-containing oxide nanoparticles in an amount of greater than or equal to about 1 mole, greater than or equal to about 2 moles, greater than or equal to about 3 moles, greater than or equal to about 5 moles, greater than or equal to about 7 moles, greater than or equal to about 8 moles, greater than or equal to about 9 moles, greater than or equal to about 10 moles, greater than or equal to about 12 moles, or greater than or equal to about 15 moles, based on 100 moles of zinc in the zinc-containing oxide nanoparticles to be produced by the reaction.

The zinc precursor may be an organic compound including zinc, and the precursor of the additional metal other than zinc may be an organic compound including an additional metal other than zinc. The zinc precursor and the precursor of the additional metal may include a carboxylate moiety, such as, for example, an acetate moiety. For example, the zinc precursor may include a zinc carboxylate, such as, for example, zinc acetate; zinc acetylacetonate; a zinc halide, such as, for example, zinc chloride, zinc bromide, zinc iodide or zinc fluoride; a zinc nitrate; a zinc oxide; or a combination thereof.

The additional metal other than zinc may be an alkaline earth metal, and the precursor of the additional metal other than zinc may be an organic compound including the additional metal, for example, a carboxylate compound (e.g., acetate), an acetylacetonate compound, a halide, a nitride, an oxide, or a combination thereof. In an embodiment, the additional metal may include magnesium, and the precursor of the magnesium may include a magnesium carboxylate (e.g., magnesium acetate), magnesium acetylacetonate, a magnesium halide (e.g., magnesium chloride, magnesium bromide, magnesium fluoride, magnesium iodide), magnesium nitrate, magnesium oxide, or a combination thereof. In an embodiment, the precursor of the additional metal may further include gallium carboxylate (e.g., gallium acetate), gallium acetylacetonate, gallium halide, gallium nitride, gallium oxide, or a combination thereof. Herein, the halide may include chloride, fluoride, bromide, or iodide.

The molar ratio between the zinc precursor and the precursor of the additional metal may be appropriately selected by taking into account the desired composition of the zinc-containing oxide nanoparticles. In an embodiment, the molar amount of the precursor of the additional metal based on 1 mole of zinc precursor may be about 0.1 mole to about 1.5 mole, about 0.2 mole to about 1 mole, about 0.3 mole to about 0.9 mole, about 0.4 mole to about 0.8 mole, about 0.5 mole to about 0.7 mole, or a combination thereof.

The first organic solvent and the second organic solvent may each independently include a C1 to C10 alcohol solvent, dimethyl sulfoxide, a substituted or unsubstituted hydrocarbon solvent having a carbon number in a range of C1 to C30, C3 to C15, or a combination thereof (e.g., a substituted or unsubstituted aliphatic hydrocarbon, a substituted or unsubstituted alicyclic hydrocarbon, a substituted or unsubstituted aromatic hydrocarbon, or a substituted or unsubstituted aromatic hydrocarbon having at least one double bond hydrogenated, or the like), or a combination thereof, and in an embodiment, the first organic solvent and the second organic solvent may be the same as, or different from each other. The first organic solvent and the second organic solvent may each independently include a C1 to C10 alcohol solvent (e.g., methanol, ethanol, n-propanol, isopropanol, n-butanol, isobutanol, n-pentanol, isopentanol, or a combination thereof), a sulfoxide solvent (e.g., dimethyl sulfoxide), a C3 to C15 hydrocarbon solvent (e.g., an aliphatic, aromatic, or cycloaliphatic solvent, or an cycloaliphatic compound obtained by the hydrogenation reaction of an aromatic hydrocarbon), or a combination thereof, and in an embodiment, the first organic solvent and the second organic solvent may be the same as, or different from each other.

In an embodiment, the first organic solvent and the second organic solvent may be different solvents from each other. In an embodiment, the first organic solvent and the second organic solvent may be solvents having a relative polarity difference of greater than or equal to about 0.3 and less than or equal to about 0.9. When a first solvent and a second solvent having such a relative polarity difference are used in combination, and when the first solution and the second solution are mixed and reacted, synthesis of the nanoparticles occurring therein may involve general phase transitions and separation mechanisms occurring at the interfaces of liquid, solid, and solution phases present in the reaction system (e.g., Liquid-Solid-Solution Synthesis, hereinafter referred to as LSS). Without wishing to be bound by a particular theory, in an embodiment, it is thought that the polarity difference of the two solvents may cause nanobubbles to form within the reaction solution (e.g., a solution or a liquid), and that at the interface between the mixture (e.g., a liquid or a solution) and the nanobubbles, precursors (solids) may migrate and react (e.g., phase transfer and/or phase separation) to form nanoparticles of an oxide including zinc and the additional metal (e.g., magnesium), and at the same time, oxo anions of vanadium derived from a compound including the oxo anions of vanadium may be adsorbed onto the surface of the zinc-containing oxide nanoparticles that are formed. Meanwhile, the cation of an alkali metal or alkaline earth metal derived from a compound including the oxo anions of vanadium may be separated and removed from the reaction mixture including the nanoparticles of the zinc-containing oxide, which are the final product, in the washing process described below performed after forming a salt with the anion of a carboxylate group or halogen that formed the zinc precursor and/or the precursor of the additional metal.

The first organic solvent and the second organic solvent may have a relative polarity difference of greater than or equal to about 0.35, greater than or equal to about 0.4, greater than or equal to about 0.45, greater than or equal to about 0.5, or greater than or equal to about 0.55. The relative polarity difference may be less than or equal to about 0.85, less than or equal to about 0.8, less than or equal to about 0.75, less than or equal to about 0.7, less than or equal to about 0.65, less than or equal to about 0.6, less than or equal to about 0.55, less than or equal to about 0.5, or less than or equal to about 0.45. The relative polarity of solvents may be obtained from the literature (e.g., Solvents and solvent Effects in organic chemistry, Wiliey VCH publisher, 3rd edition, 2003). The relative polarity value of water is 1.

The first organic solvent may include a C1 to C10 alcohol solvent, such as, for example, methanol, ethanol, n-propanol, isopropanol, n-butanol, isobutanol, n-pentanol, isopentanol, or a combination thereof. The relative polarity value of the first solvent may be greater than or equal to about 0.4, greater than or equal to about 0.45, greater than or equal to about 0.5, greater than or equal to about 0.55, greater than or equal to about 0.6, greater than or equal to about 0.65, greater than or equal to about 0.7, or greater than or equal to about 0.75. The relative polarity value of the first organic solvent may be less than or equal to about 1, or less than or equal to about 0.9.

The second organic solvent may be a C3 to C30 (e.g., C3 to C15) hydrocarbon solvent (e.g., an aliphatic hydrocarbon solvent, an aromatic hydrocarbon solvent, an alicyclic hydrocarbon solvent, or a solvent having a benzene ring having one or more double bonds hydrogenated), dimethyl sulfoxide, or the like. The second organic solvent may include, for example, cyclohexane, hexane, heptane, nonane, octane, toluene, cyclohexene, xylene, and the like. The relative polarity value of the second organic solvent may be greater than or equal to about 0.001, greater than or equal to about 0.003, greater than or equal to about 0.006, greater than or equal to about 0.009, greater than or equal to about 0.01, or greater than or equal to about 0.012

The relative polarity value of the second oranic solvent may be less than or equal to about 4, less than or equal to about 3.5, less than or equal to about 3, less than or equal to about 2.5, less than or equal to about 2, less than or equal to about 1.5, less than or equal to about 1, or less than or equal to about 0.5.

The second organic solvent may form nanobubbles within the first organic solvent. The volume ratio of the first organic solvent to the second organic solvent (i.e., the first organic solvent: the second organic solvent) may be about 1:0.2 to about 1:5, about 1:0.3 to about 1:3, about 1:0.5 to about 1:2, about 1:0.8 or about 1:1.25, about 1:1 to about 1:1.5, or a combination thereof.

The organic solvent (or the ETL forming composition described below) may not include butylamine, ethylamine, ethanolamine, hexamethylenediamine, aniline, hexylamine, or a combination thereof. The above organic solvent (or the composition for forming ETL described below) may not include an organic amine having C1 to C12, an aromatic amine having a benzene group, or a combination thereof.

The mixing and reacting of the first solution and the second solution may include stirring and reacting the mixture at, for example, a predetermined temperature (for example, a temperature of greater than or equal to about 40 °C and less than or equal to about 80 °C). The stirring may be performed at, for example, greater than or equal to about 100 revolutions per minute (rpm), greater than or equal to about 150 rpm, greater than or equal to about 200 rpm, greater than or equal to about 250 rpm, greater than or equal to about 300 rpm, greater than or equal to about 350 rpm, greater than or equal to about 400 rpm, greater than or equal to about 450 rpm, greater than or equal to about 500 rpm. The stirring may be performed at, for example, less than or equal to about 800 rpm, less than or equal to about 700 rpm, or less than or equal to about 600 rpm. The temperature may be greater than or equal to about 40 °C, for example, greater than or equal to about 50 °C, or greater than or equal to about 60 °C. The temperature may be less than or equal to a boiling point of the first organic solvent and/or the second organic solvent, or less than or equal to about 78 °C, less than or equal to about 75 °C, for example, less than or equal to about 70 °C, less than or equal to about 65 °C, or less than or equal to about 60 °C.

The preparing method may further include, after reacting the first solution and the second solution, adding a third solvent that is not miscible with the first organic solvent and the second organic solvent to the reaction mixture to form a precipitate. The third solvent is an antisolvent that does not mix with the first organic solvent and the second organic solvent, and enables the zinc-containing oxide nanoparticles formed from the reaction solution to be precipitated and separated. By adding the third solvent to the solution where the reaction is completed and stirring, precipitation of zinc-containing oxide nanoparticles is induced, and the resulting precipitate may be separated, for example, through centrifugation. After separating the precipitate, the precipitate may be washed by further using the third solvent and dried using to obtain the final produced zinc-containing oxide nanoparticles. The third solvent may be ethyl acetate.

The zinc-containing oxide nanoparticles prepared as described above include an additional metal in addition to zinc, such as an alkaline earth metal, zirconium (Zr), tungsten (W), titanium (Ti), yttrium (Y), aluminum (Al), gallium (Ga), indium (In), tin (Sn), cobalt (Co), vanadium (V), or a combination thereof, and have oxo anions of vanadium on a surface thereof. It can be confirmed through XPS analysis, or other analytical methods known in the art, that the zinc-containing oxide nanoparticles prepared in this way include the oxo anions of vanadium on a surface thereof. That is, as demonstrated from the examples described below, the zinc-containing oxide nanoparticles prepared by the method according to an embodiment exhibit, in XPS analysis, a V2p3 peak intensity (3.64) derived from the oxo anions of vanadium that is significantly greater than the K2p peak intensity (0.08) of potassium, an alkali metal derived from a compound including oxo anions of vanadium, for example, potassium metavanadate. That is, it can be seen that oxo anions of vanadium derived from potassium metavanadate well passivate the surface of zinc-containing oxide nanoparticles according to an embodiment prepared from the preparing method. On the other hand, as in the comparative preparation examples described below, when zinc-containing oxide nanoparticles are first synthesized and then potassium metavanadate powder is simply added thereto, the XPS results of the nanoparticles obtained therefrom showed that both the K2p peak intensity (3.06) of potassium and the V2p3 peak intensity (4.22) of vanadium are high. This indicates that potassium metavanadate added in powder form does not undergo any additional reaction with the previously prepared zinc-containing oxide nanoparticles, but exists in a simply mixed state.

In addition, the prepared zinc-containing oxide nanoparticles may have a first absorption peak in a wavelength range of greater than or equal to about 285 nm, greater than or equal to about 289 nm, greater than or equal to about 292 nm, or greater than or equal to about 295 nm, and less than or equal to about 330 nm, less than or equal to about 315 nm, less than or equal to about 302 nm, less than or equal to about 300 nm, less than or equal to about 299 nm, less than or equal to about 298 nm, or less than or equal to about 297 nm. The zinc oxide nanoparticles may have a first absorption peak wavelength in a UV-Vis absorption spectrum of less than or equal to about 320 nm, less than or equal to about 319 nm, less than or equal to about 318 nm, less than or equal to about 317 nm, less than or equal to about 316 nm, less than or equal to about 315 nm, less than or equal to about 314 nm, less than or equal to about 313 nm, less than or equal to about 312 nm, or less than or equal to about 311 nm. The first absorption peak wavelength may be greater than or equal to about 290nm. The first absorption peak wavelength may be greater than or equal to about 295 nm, greater than or equal to about 300 nm, greater than or equal to about 301 nm, greater than or equal to about 302 nm, or greater than or equal to about 303 nm.

The zinc oxide nanoparticles may exhibit a valley adjacent to the first absorption peak in UV-Vis absorption spectroscopy, and may have a valley depth (VD) defined by the following equation of greater than or equal to about 0.01, greater than or equal to about 0.02, greater than or equal to about 0.027, greater than or equal to about 0.03, greater than or equal to about 0.035, greater than or equal to about 0.04, greater than or equal to about 0.045, greater than or equal to about 0.05, greater than or equal to about 0.055, or greater than or equal to about 0.06: $1 - \left({Abs}_{valley}/{Abs}_{first}\right) = VD$

In the equation, Abs_{first} is an absorption at the first absorption peak, and Abs_{valley} is an absorption at the lowest point of the valley adjacent to the first absorption peak.

The valley depth may be less than or equal to about 0.2, less than or equal to about 0.15, less than or equal to about 0.1, less than or equal to about 0.08, less than or equal to about 0.07, or less than or equal to about 0.06.

The zinc oxide nanoparticles may have a band gap energy determined by the x-intercept value in UV-Vis absorption spectroscopy of greater than or equal to about 3.6 eV, greater than or equal to about 3.65 eV, greater than or equal to about 3.7 eV, greater than or equal to about 3.75 eV, greater than or equal to about 3.77 eV, greater than or equal to about 3.78 eV, and less than or equal to about 3.95 eV, less than or equal to about 3.94 eV, less than or equal to about 3.9 eV, less than or equal to about 3.85 eV, less than or equal to about 3.8 eV, less than or equal to about 3.78 eV, less than or equal to about 3.77 eV, less than or equal to about 3.75 eV, or less than or equal to about 3.7 eV.

As demonstrated in Examples described below, the zinc-containing oxide nanoparticles prepared as described above have a wider band gap and an upwardly adjusted minimum value of the conductive band (CBM) compared to zinc-containing oxide nanoparticles that do not include the oxo anions of vanadium on the surface, so that an electroluminescent diode including the zinc-containing oxide nanoparticles in an electron transport layer can have significantly improved performance and life-span by lowering the electron conduction barrier from the electron transport layer to the light emitting layer including the quantum dots and thereby increasing the conductive characteristics.

Without wishing to be bound by a particular theory, it is thought that zinc-containing oxide nanoparticles according to an embodiment have surface passivation by the carboxylate moiety included in the zinc precursor and/or the precursor of the additional metal, the hydroxy moiety derived from the basic compound, and the like, as well as surface passivation by the oxo anions of vanadium, thereby more effectively passivating zinc dangling bonds present on the surface of the nanoparticles. In addition, the zinc-containing oxide nanoparticles of an embodiment may have a composition of surface ligands different from those of the prior art, and thus, it is thought that the leakage current of the device can be reduced through trap passivation of the particles, the balance of electrons and holes can be maintained, and thus the efficiency and life-span of the electroluminescent diode can be increased.

Therefore, the zinc-containing oxide nanoparticles according to an embodiment can be applied as a material forming an electron transport layer of an electroluminescent diode including quantum dots in a light emitting layer. An electroluminescent diode according to an embodiment is a self-luminous type luminescent diode configured to emit desired light by voltage application without a separate light source. Hereinafter, an electroluminescent diode according to an embodiment is described in detail with reference to the drawings.

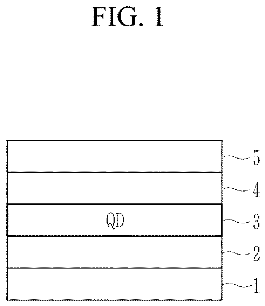

Referring to FIG. 1, the electroluminescent diode includes a first electrode 1 and a second electrode 5 which are spaced apart from each other (e.g., facing each other); a light emitting layer 3 disposed between the first electrode and the second electrode and including a plurality of semiconductor nanoparticles; and an electron transport layer 4 between the light emitting layer 3 and the second electrode 5. The above electroluminescent diode may further include a hole auxiliary layer 2 between the light emitting layer and the first electrode. The hole auxiliary layer may include a hole transport layer (e.g., including an organic compound), a hole injection layer, an electron blocking layer, or a combination thereof.

The first electrode or the second electrode may be an anode or a cathode. In an embodiment, the first electrode may be a cathode (or anode) and the second electrode may be an anode (or cathode). In an embodiment, the second electrode may be a cathode.

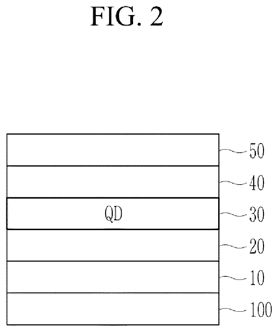

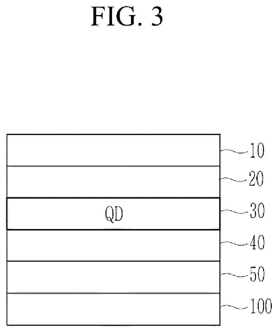

Referring to FIGS. 2 and 3, in the electroluminescent diode, the first electrode or the second electrode may be disposed on a (transparent) substrate 100. The transparent substrate may be a light extraction surface.

In FIGS. 2 and 3, a light emitting layer 30 may be disposed between a first electrode (e.g., anode) 10 and a second electrode (e.g., cathode) 50. The second electrode or cathode 50 may include an electron injection conductor. The first electrode or anode 10 may include a hole injection conductor. The work function of the electron/hole injection conductor included in the second electrode and the first electrode can be appropriately controlled and is not particularly limited. For example, the second electrode may have a small work function and the first electrode may have a relatively large work function, or vice versa.

The electron/hole injection conductors may include a metal-containing material (e.g., a metal, a metal compound, an alloy, or a combination thereof) (e.g., aluminum, magnesium, tungsten, nickel, cobalt, platinum, palladium, calcium, LiF, or the like.), a metal oxide such as gallium indium oxide or indium tin oxide (ITO), or a conductive polymer (e.g., having a relatively high work function) such as polyethylene dioxythiophene, but are not limited thereto.

At least one of the first electrode and the second electrode may be a light-transmitting electrode or a transparent electrode. In an embodiment, both the first electrode and the second electrode can be light-transmitting electrodes. The electrode(s) may be patterned. The first electrode and/or the second electrode may be disposed on a (e.g., insulating) substrate 100. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and for example, less than or equal to about 99%, or less than or equal to about 95%). The substrate may include a region for a blue pixel, a region for a red pixel, a region for a green pixel, or a combination thereof. A thin film transistor may be disposed in each region of the substrate, and one of a source electrode and a drain electrode of the thin film transistor may be electrically connected to the first electrode or the second electrode.

The light transmitting electrode may be disposed on a (e.g., insulating) transparent substrate. The substrate may be rigid or flexible. The substrate may be plastic, glass, or a metal.

The light transmitting electrode may be made of, for example, a transparent conductor such as indium tin oxide (ITO) or indium zinc oxide (IZO), gallium indium tin oxide, zinc indium tin oxide, titanium nitride, polyaniline, LiF/Mg:Ag, or the like, or a thin metal thin film of a single layer or a plurality of layers, but is not limited thereto. When one of the first electrode and the second electrode is an opaque electrode, it may be made of an opaque conductor such as aluminum (Al), a lithium-aluminum (Li:Al) alloy, a magnesium-silver alloy (Mg;Ag), and lithium fluoride-aluminum (LiF:Al).

The thickness of the electrode (first electrode and/or second electrode) is not particularly limited and may be appropriately selected in consideration of device efficiency. For example, the thickness of the electrode may be greater than or equal to about 5 nm, for example, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 µm, for example, less than or equal to about 90 µm, less than or equal to about 80 µm, less than or equal to about 70 µm, less than or equal to about 60 µm, less than or equal to about 50 µm, less than or equal to about 40 µm, less than or equal to about 30 µm, less than or equal to about 20 µm, less than or equal to about 10 µm, less than or equal to about 1 µm, less than or equal to about 900 nm, less than or equal to about 500 nm, or less than or equal to about 100 nm.

The method of forming the electrode is not particularly limited and can be appropriately selected depending on the material. In an embodiment, the electrode may be formed by, but is not limited to, deposition, coating, or a combination thereof.

In FIGS. 1 to 3, a light emitting layer (EML) 3 or 30 is disposed between a first electrode 1 or 10 and a second electrode 5 or 50 (e.g., an anode 1 or 10 and a cathode 5 or 50). The light emitting layer may include semiconductor nanoparticle(s) (e.g., blue light emitting nanoparticles, red light emitting nanoparticles, or green light emitting nanoparticles). The light emitting layer may include one or more (e.g., 2 or more or 3 or more and 10 or less) monolayers of a plurality of nanoparticles.

The light emitting layer may be patterned. In an embodiment, the patterned light emitting layer may include a blue light emitting layer (e.g., disposed within a blue pixel in a display device to be described later), a red light emitting layer (e.g., disposed within a red pixel in a display device to be described later), and a green light emitting layer (e.g., disposed within a green pixel in a display device to be described later)), or a combination thereof. Each of the light emitting layers may be (e.g., optically) separated from an adjacent light emitting layer by a partition wall. In an embodiment, a partition wall such as a black matrix may be disposed between the red light emitting layer(s), the green light emitting layer(s), and the blue light emitting layer(s). In nonlimiting embodiments, the red light emitting layer, the green light emitting layer, and the blue light emitting layer may each be isolated.

The light emitting layer or semiconductor nanoparticle(s) may not include cadmium. The light emitting layer or semiconductor nanoparticle(s) may not include mercury, lead, or a combination thereof.

In an embodiment, the semiconductor nanoparticles may have a core-shell structure. The semiconductor nanoparticles may include a core including a first semiconductor nanocrystal and a shell including a second semiconductor nanocrystal disposed on the core and having a composition different from that of the first semiconductor nanocrystal.

The semiconductor nanoparticles (e.g., first semiconductor nanocrystal and/or the second semiconductor nanocrystal) may include a semiconductor compound or material, for example a Group II-VI compound, a Group III-V compound, a Group IV-VI compound, a Group IV element or a Group IV element compound, a Group I-III-VI compound, a Group I-II-IV-VI compound, or a combination thereof. The light emitting layer (or semiconductor nanoparticles, first semiconductor nanocrystal, or second semiconductor nanocrystal) may not include hazardous heavy metals such as cadmium, lead, mercury, or a combination thereof.

The Group II-VI compound may be at least of one of binary compound of ZnS, ZnSe, ZnTe, ZnO, HgS, HgSe, HgTe, MgSe, MgS, or a mixture thereof; a ternary compound of ZnSeS, ZnSeTe, ZnSTe, HgSeS, HgSeTe, HgSTe, HgZnS, HgZnSe, HgZnTe, MgZnSe, MgZnS, or a mixture thereof; and a quaternary compound of HgZnTeS, HgZnSeS, HgZnSeTe, HgZnSTe, or a mixture thereof. The Group II-VI compound may further include a Group III metal.

The Group III-V compound may be at least one of binary compound of GaN, GaP, GaAs, GaSb, AIN, AlP, AlAs, AlSb, InN, InP, InAs, InSb, or a mixture thereof; a ternary compound of GaNP, GaNAs, GaNSb, GaPAs, GaPSb, AINP, AlNAs, AlNSb, AlPAs, AlPSb, InNP, InNAs, InNSb, InPAs, InPSb, or a mixture thereof, and a quaternary compound of GaAlNP, GaAINAs, GaAINSb, GaAlPAs, GaAlPSb, GaInNP, GaInNAs, GaInNSb, GaInPAs, GaInPSb, InAlNP, InAINAs, InAINSb, InAlPAs, InAlPSb, or a mixture thereof. The Group III-V compound may further include a Group II element. An example of such a semiconductor nanocrystal may include InZnP.

The Group IV-VI compound may be at least one of binary compound of SnS, SnSe, SnTe, or a mixture thereof; a ternary compound of SnSeS, SnSeTe, SnSTe, or a mixture thereof; and a quaternary compound, such as SnSSeTe.

Examples of the Group I-III-VI compound may include CuInSe₂, CuInS₂, CulnGaSe, and CulnGaS, but are not limited thereto. Examples of the Group I-III-VI semiconductor compound may include a ternary element compound, such as AgInS, AgInS₂, AgInSe₂, AgGaS, AgGaS₂, AgGaSe₂, CulnS, CuInS₂, CuInSe₂, CuGaS₂, CuGaSe₂, CuGaO₂, AgGaO₂, AgAlO₂, and the like; a quaternary element compound, such as AgInGaS₂, AgInGaSe₂, and the like; or any combination thereof.

Examples of the group I-II-IV-VI compound may include, but are not limited to, CuZnSnSe and CuZnSnS.

The Group IV element or compound may be at least one of single element (elementary substance) of Si, Ge, or a mixture thereof; and a binary compound of SiC, SiGe, or a mixture thereof.

Each element included in a multi-element compound, such as the binary compound, ternary compound, or quaternary compound, may exist within the particle in a uniform or non-uniform concentration. For example, the chemical formula above indicates the type of elements included in the compound, and the element ratio within the compound may be different. For example, AgInGaS₂ can mean AgInxGa₁₋ₓS₂ (where x is a real number between 0 and 1).

In an embodiment, the first semiconductor nanocrystal may include a metal including indium, zinc, or a combination thereof, and a non-metal including phosphorus, selenium, tellurium, sulfur, or a combination thereof. In an embodiment, the second semiconductor nanocrystal may include a metal including indium, zinc, or a combination thereof, and a non-metal including phosphorus, selenium, tellurium, sulfur, or a combination thereof.

In an embodiment, the first semiconductor nanocrystal may include InP, InZnP, ZnSe, ZnSeS, ZnSeTe, or a combination thereof and/or the second semiconductor nanocrystal may include ZnSe, ZnSeS, ZnS, ZnTeSe, or a combination thereof. In an embodiment, the shell may include zinc, sulfur, and optionally selenium in the outermost layer.

In an embodiment, the semiconductor nanoparticles may emit blue or green light and have a core including ZnSeTe, ZnSe, or a combination thereof and a shell including zinc chalcogenide (e.g., ZnS, ZnSe, and/or ZnSeS). A content of sulfur in the shell may increase or decrease in the radial direction (from the core towards the surface).

In an embodiment, the semiconductor nanoparticles may emit red or green light, the core may include InP, InZnP, or a combination thereof, and the shell may include a Group 2 metal including zinc and a non-metal including at least one of sulfur and selenium.

The plurality of semiconductor nanoparticles may include a first semiconductor nanocrystal including zinc, selenium, and tellurium, and may include a second semiconductor nanocrystal including and a zinc chalcogenide and being different from the first semiconductor nanocrystal.

The plurality of semiconductor nanoparticles may include a first semiconductor nanocrystal including indium, phosphorus, and optionally zinc, and a second semiconductor nanocrystal including a zinc chalcogenide and being different from the first semiconductor nanocrystal. The plurality of semiconductor nanoparticles may include zinc chalcogenide, and the zinc chalcogenide may comprise tellurium, and optionally, the plurality of semiconductor nanoparticles may be configured to emit blue light. The plurality of semiconductor nanoparticles may include a core including the first semiconductor nanocrystal, and a shell, including the second semiconductor nanocrystal, disposed on the core.

In an embodiment, when the semiconductor nanoparticles have a core/shell structure, an alloyed layer may or may not be present at the interface between the core and the shell. The alloyed layer may be a homogeneous alloy or may be a gradient alloy. In the gradient alloy, a concentration of elements present in the shell may have a concentration gradient that changes in the radial direction (e.g., decreases or increases toward the center).

In an embodiment, the shell may have a composition which is changed in a radial direction. In an embodiment, the shell may be a multilayered shell including two or more layers. In the multilayered shell, adjacent two layers may have different compositions from each other. In the multilayered shell, at least one layer may each independently include a semiconductor nanocrystal having a single composition. In the multilayered shell, at least one layer may independently have an alloyed semiconductor nanocrystal. In the multilayered shell, at least one layer may have a concentration gradient that radially changes in terms of a composition of a semiconductor nanocrystal.

In the core/shell structured semiconductor nanoparticle, the band gap energy of the shell material may be greater than that of the core material, but is not limited thereto. The band gap energy of the shell material may be smaller than that of the core material. In the case of the multilayered shell, the energy band gap of the outermost layer material of the shell may be greater than those of materials of the core and the inner layer of the shell (layers that are closer to the core). In the multilayered shell, a semiconductor nanocrystal of each layer may be selected to have an appropriate band gap, thereby effectively showing a quantum confinement effect.

The semiconductor nanoparticles of an embodiment may include, for example, an organic ligand in a state in which they are bonded or coordinated to a surface of the semiconductor nanoparticles. The organic ligands are as described below.

In an embodiment, the semiconductor nanoparticle may control the absorption/emission wavelength by, for example, adjusting its composition and/or size. The semiconductor nanoparticle included in the light emitting layer 3 or 30 may be configured to emit light of a desired color. The semiconductor nanoparticle may include a blue light emitting semiconductor nanoparticle, a green light emitting semiconductor nanoparticle, or a red light emitting semiconductor nanoparticle.

The maximum emission peak wavelength of the semiconductor nanoparticles can have a wavelength range from ultraviolet to infrared wavelengths or higher. For example, the maximum emission peak wavelength of the semiconductor nanoparticle may be greater than or equal to about 300 nm, for example, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The maximum emission wavelength of the semiconductor nanoparticle may be in the range of less than or equal to about 800 nm, for example, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The maximum emission wavelength of the semiconductor nanoparticle may be in the range of about 500 nm to about 650 nm.

The semiconductor nanoparticle may emit green light, and the maximum emission wavelength may be in the range of greater than or equal to about 500 nm (e.g., greater than or equal to about 520 nm) and less than or equal to about 560 nm (e.g., less than or equal to about 540 nm or less than or equal to about 530 nm). The semiconductor nanoparticle may emit red light, and the maximum emission wavelength may be in the range of greater than or equal to about 600 nm (e.g., greater than or equal to about 610 nm) and less than or equal to about 650 nm (e.g., less than or equal to about 640 nm). The semiconductor nanoparticle may emit blue light and the maximum emission wavelength may be greater than or equal to about 440 nm (e.g., greater than or equal to about 450 nm or greater than or equal to about 455nm) and less than or equal to about 480 nm (e.g., less than or equal to about 470 nm or less than or equal to about 465 nm).

The semiconductor nanoparticle may exhibit a photoluminescence spectrum with a relatively narrow full width at half maximum (FWHM). In an embodiment, the semiconductor nanoparticle may have FWHM of less than or equal to about 45 nm, for example less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm in the photoluminescence spectrum thereof.

The semiconductor nanoparticle may have (e.g., be configured to implement) a quantum yield of greater than or equal to about 10%, for example, greater than or equal to about 20%, greater than or equal to about 30%, greater than or equal to about 40%, greater than or equal to about 50%, greater than or equal to about 60%, greater than or equal to about 70%, greater than or equal to about 80%, greater than or equal to about 90%, or even about 100%.

The semiconductor nanoparticle may have a size (e.g., a particle diameter or an equivalent particle diameter calculated from a two-dimensional area confirmed by electron microscopy analysis in the case of non-spherical particles) of greater than or equal to about 1 nm and less than or equal to about 100 nm. In an embodiment, the semiconductor nanoparticle may have a size of about 1 nm to about 50 nm, for example, about 2 nm (or about 3 nm) to about 35 nm. In an embodiment, the size of the semiconductor nanoparticle may be greater than or equal to about 1 nm, greater than or equal to about 2 nm, greater than or equal to about 3 nm, greater than or equal to about 4 nm, or greater than or equal to about 5 nm. In an embodiment, the size of the semiconductor nanoparticle may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, or less than or equal to about 15 nm.

The semiconductor nanoparticle may have any shape. In an embodiment, the shape of the semiconductor nanoparticle may be a sphere, a polyhedron, a pyramid, a multi-pod, a cube, a nanotube, a nanowire, a nanofiber, a nanosheet, a nanoplate, or a combination thereof.

The semiconductor nanoparticle may be synthesized by any method. For example, the semiconductor nanocrystal having a size of several nanometers may be synthesized through a wet chemical process. In the wet chemical process, crystal particles are grown by reacting precursor materials in an organic solvent, and growth of crystals may be controlled by coordinating the organic solvent or ligand compound on the surface of the semiconductor nanocrystals.

In an embodiment, for example, the method of preparing the semiconductor nanoparticle having the core/shell structure may include obtaining the core; preparing a first shell precursor including a metal (e.g., zinc) and a first shell precursor solution including an organic ligand; preparing a second shell precursor including a non-metal element (e.g., sulfur, selenium, or a combination thereof); and heating the first shell precursor solution at a reaction temperature (e.g., greater than or equal to about 180 °C, greater than or equal to about 200 °C, greater than or equal to about 240 °C, or greater than or equal to about 280 °C and less than or equal to about 360 °C, less than or equal to about 340 °C, or less than or equal to about 320 °C), and then, adding the core and the second shell precursor thereto (e.g., one or more times, or two or more times) to form a shell of second semiconductor nanocrystals on the first semiconductor nanocrystal core. The method may include preparing a core solution by separating the core from a reaction system used for preparing the core, and then, dispersing it in an organic solvent.

In an embodiment, in order to form the shell, a solvent and optionally, a ligand compound may be heated at a predetermined temperature (e.g., greater than or equal to about 100 °C) under vacuum (or vacuum-treated), and then, after substituting the atmosphere with an inert gas atmosphere, heat-treated again at a predetermined temperature (e.g., greater than or equal to 100 °C). Subsequently, the core may be added thereto, and the shell precursors may be sequentially or simultaneously added thereto, and then, heated at a predetermined reaction temperature to perform a reaction. The shell precursors may be sequentially introduced in different proportions of the mixture during the reaction time.

In an embodiment of the semiconductor nanoparticles, the core may be prepared by a suitable method. The organic solvent may include a C6 to C22 primary amine, such as a hexadecylamine, a C6 to C22 secondary amine, such as dioctylamine, a C6 to C40 tertiary amine, such as a trioctyl amine, a nitrogen-containing heterocyclic compound, such as pyridine, a C6 to C40 olefin, such as octadecene, a C6 to C40 aliphatic hydrocarbon, such as hexadecane, octadecane, or squalane, an aromatic hydrocarbon substituted with a C6 to C30 alkyl group, such as phenyldodecane, phenyltetradecane, or phenyl hexadecane, a primary, secondary, or tertiary phosphine (e.g., trioctylphosphine) substituted with at least one (e.g., 1, 2, or 3) C6 to C22 alkyl group, a phosphine oxide (e.g. trioctylphosphine oxide) substituted with a (e.g., 1, 2, or 3) C6 to C22 alkyl group, a C12 to C22 aromatic ether, such as phenyl ether or benzyl ether, or a combination thereof.

The organic ligand coordinates a surface of the manufactured semiconductor nanoparticle and can enable the semiconductor nanoparticle to be well dispersed in a solution. The organic ligand may include RCOOH, RNH₂, R₂NH, R₃N, RSH, RH₂PO, R₂HPO, R₃PO, RH₂P, R₂HP, R₃P, ROH, RCOOR', RPO(OH)₂, R₂POOH wherein R and R' each independently include a substituted or unsubstituted C1 or more, C6 or more, or C10 or more and C40 or less, C35 or less, or C25 or aliphatic hydrocarbon group, or substituted or unsubstituted C6 to C40 aromatic hydrocarbon group, or a combination thereof), or a combination thereof. The ligands may be used alone or as a mixture of two or more compounds.

Examples of the organic ligand may be a thiol compound, such as methane thiol, ethane thiol, propane thiol, butane thiol, pentane thiol, hexane thiol, octane thiol, dodecane thiol, hexadecane thiol, octadecane thiol, benzyl thiol, and the like; amines, such as methane amine, ethane amine, propane amine, butane amine, pentyl amine, hexyl amine, octyl amine, nonylamine, decylamine, dodecyl amine, hexadecyl amine, octadecyl amine, dimethyl amine, diethyl amine, dipropyl amine, tributylamine, trioctylamine, and the like; a carboxylic acid compound, such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, myristic acid, stearic acid, lauric acid, benzoic acid, and the like; a phosphine compound, such as methyl phosphine, ethyl phosphine, propyl phosphine, butyl phosphine, pentyl phosphine, octylphosphine, dioctyl phosphine, tributylphosphine, trioctylphosphine, and the like; a phosphine oxide compound thereof, such as methyl phosphine oxide, ethyl phosphine oxide, propyl phosphine oxide, butyl phosphine oxide pentyl phosphineoxide, tributylphosphineoxide, octylphosphine oxide, dioctyl phosphineoxide, trioctylphosphineoxide, , and the like; diphenyl phosphine (DPP), triphenyl phosphine compound, or an oxide compound thereof; C5 to C20 alkyl phosphinic acid, such as hexylphosphinic acid, octylphosphinic acid, dodecanephosphinic acid, tetradecanephosphinic acid, hexadecanephosphinic acid, octadecanephosphinic acid, C5 to C20 alkyl phosphonic acid; and the like, but are not limited thereto.

The semiconductor nanocrystals may be recovered by pouring into an excess of nonsolvent to remove excess organic matter not coordinated on the surface, and centrifuging the resulting mixture. For example, after the reaction is completed, if a nonsolvent is added to the reaction product, the semiconductor nanoparticles coordinated with the ligand compound may be separated. The nonsolvent may be a polar solvent that is miscible with the solvent used in the core formation and/or shell formation reactions and is not capable of dispersing the prepared nanocrystals. The nonsolvent may be selected depending on the solvent used in the reaction and may include, for example, acetone, ethanol, butanol, isopropanol, ethanediol, water, tetrahydrofuran (THF), dimethylsulfoxide (DMSO), diethylether, formaldehyde, acetaldehyde, ethylene glycol, a solvent having a similar solubility parameter to the foregoing solvents, or a combination thereof. The semiconductor nanocrystal may be separated through centrifugation, sedimentation, chromatography, or distillation. The separated nanocrystals may be added to a washing solvent and washed, if needed. The washing solvent has no particular limit and may have a similar solubility parameter to that of the ligand, and may, for example, include hexane, heptane, octane, chloroform, toluene, benzene, and the like.

The semiconductor nanoparticles may be non-dispersible or insoluble in water, the aforementioned nonsolvent, or a combination thereof. The semiconductor nanoparticles may be dispersed in the aforementioned organic solvent. In an embodiment, the semiconductor nanoparticles may be dispersed on C6 to C40 aliphatic hydrocarbon, substituted or unsubstituted C6 to C40 aromatic hydrocarbon, or a combination thereof.

In the display device or luminescent diode, the thickness of the light emitting layer may be appropriately selected. In an embodiment, the light emitting layer may include a monolayer(s) of semiconductor nanoparticles. In another embodiment, the light emitting layer may include one or more, for example, two or more, three or more, or four or more and 20 or less, 10 or less, 9 or less, 8 or less, 7 or less, or 6 or less monolayers of the semiconductor nanoparticles. The light emitting layer may have a thickness of greater than or equal to about 5 nm, for example, greater than or equal to about 10 nm, greater than or equal to about 20 nm, greater than or equal to about 25 nm, or greater than or equal to about 30 nm, and less than or equal to about 200 nm, for example, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm, and the light emitting layer may have a thickness of, for example about 10 nm to about 150 nm, for example about 20 nm to about 100 nm, for example about 30 nm to about 50 nm.

The forming the light emitting layer 3 or 30 can be performed by obtaining a composition including semiconductor nanoparticles (configured to emit the desired light) and applying or depositing it on a substrate (e.g., an electrode) or a charge auxiliary layer (e.g., a hole auxiliary layer or an electron auxiliary layer) by an appropriate method (e.g., by spin coating, inkjet printing, or other methods known in the art).

The forming of the light emitting layer may include contacting the applied or deposited semiconductor nanoparticle layer with, for example, a metal halide (e.g., zinc chloride) organic solution (e.g., an alcohol solution).

The forming of the light emitting layer may include heat-treating the applied or deposited semiconductor nanoparticle layer. The heat treatment temperature is not particularly limited and may be appropriately selected considering the boiling point of the organic solvent, and like considerations. For example, the heat treatment temperature may be greater than or equal to about 60 °C. The type of organic solvent for the semiconductor nanoparticle dispersion is not particularly limited and may be appropriately selected. In an embodiment, the organic solvent may include a (substituted or unsubstituted) aliphatic hydrocarbon organic solvent, a (substituted or unsubstituted) aromatic hydrocarbon organic solvent, an acetate solvent, or a combination thereof.

The light emitting layer may have a single layer structure or a multilayer structure in which two or more layers are stacked. Adjacent layers in the multilayer structure (e.g., a first light emitting layer and a second light emitting layer) may be configured to emit the same color. In a multilayer structure, adjacent layers (e.g., a first light emitting layer and a second light emitting layer) may have the same or different compositions and/or ligands from each other. In an embodiment, the light emitting layer or the multilayer light emitting layer including two or more layers may have a halogen content that changes in a thickness direction. In the (multilayer) light emitting layer according to an embodiment, the halogen content may increase towards the electron auxiliary layer. In the (multilayer) light emitting layer according to an embodiment, the organic ligand content may decrease towards the electron auxiliary layer. In the light emitting layer according to an embodiment, the halogen content may decrease toward the electron auxiliary layer. In the (multilayer) light emitting layer according to an embodiment, the organic ligand content may increase towards the electron auxiliary layer.

In an embodiment, the light emitting layer may include a first semiconductor nanoparticle light emitting layer substituted with halogen (e.g., chlorine) on a surface thereof, and a second semiconductor nanoparticle light emitting layer disposed on the first semiconductor nanoparticle light emitting layer and having an increased organic ligand content. A halogen (e.g., chlorine) content and the organic material content of the light emitting layer may be controlled by appropriate means (a post treatment for the formed layer). For example, the amount of the organic ligand of the semiconductor nanoparticles in the light emitting layer can be controlled (reduced) by treating the layer with an alcoholic solution of a metal halide (e.g., zinc halide, such as zinc chloride). Layers thus treated may have increased halogen content and may exhibit altered solubility properties with respect to organic solvents. Accordingly, a layer of semiconductor nanoparticles having different amount of organic ligands (e.g., halogen-treated semiconductor nanoparticles or semiconductor nanoparticles having carboxylic acid-containing ligands) may subsequently be formed on the treated light emitting layer.

An electron transport layer 4 or 40 may be disposed between the second electrode and the light emitting layer. The electron transport layer may be adjacent to the light emitting layer (e.g., disposed directly on the light emitting layer). In an embodiment, the electron transport layer may be in contact with the light emitting layer. An electron injection layer may further be disposed between the second electrode and the electron transport layer.

The electron transport layer may include zinc-containing oxide nanoparticle(s) according to an embodiment. As the zinc-containing oxide nanoparticles have been described above, a detailed description thereof will be omitted.

As described above, the zinc-containing oxide nanoparticles according to an embodiment can effectively passivate zinc dangling bonds on a surface of the nanoparticles by including oxo anions of vanadium on the surface, and thus, the band gap is thought to be expanded and the conductivity band minimum (CBM) is upshifted compared to zinc-containing oxide nanoparticles that do not include oxo anions of vanadium on the surface. Accordingly, an electroluminescent diode including the zinc-containing oxide nanoparticles according to an embodiment in an electron transport layer can have significantly improved performance and life-span of the device by lowering the electron conduction barrier from the electron transport layer to the quantum dot-containing light emitting layer, thereby increasing the conductivity characteristics.

The electron transport layer may be formed by obtaining a composition including the zinc-containing oxide nanoparticles according to an embodiment, for example, a composition for forming an electron transport layer prepared by dispersing the zinc-containing oxide nanoparticles in an organic solvent (for example, a polar organic solvent, a non-polar organic solvent, or a combination thereof), and applying the same to form a film. The composition for the electron transport layer may be applied on the light emitting layer. The solution process may further include removing the organic solvent from the formed film (e.g., by evaporation, or the like or a heat treatment). The heat treatment may be performed at a temperature of greater than or equal to about 50 °C, greater than or equal to about 60 °C, greater than or equal to about 70 °C, or greater than or equal to about 85 °C, and less than or equal to about 100 °C. The composition may be, for example, a dispersion in which zinc-containing oxide nanoparticles according to an embodiment are dispersed in an organic solvent.

The zinc-containing oxide nanoparticles according to an embodiment may exhibit a dispersibility required for the process, for example, the zinc-containing oxide nanoparticles may have an average particle diameter (hereinafter, referred to as "Dynamic Light Scattering (DLS) average particle diameter") of greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, or greater than or equal to about 7.5 nm, which is measured by dispersing the zinc-containing oxide nanoparticles in an alcoholic solvent in accordance with the DLS analysis. The DLS average particle diamerter of the zinc oxide nanoparticles may be less than or equal to about 500 nm, less than or equal to about 300 nm, less than or equal to about 150 nm, less than or equal to about 100 nm, less than or equal to about 50 nm, less than or equal to about 40 nm, less than or equal to about 30 nm, less than or equal to about 20 nm, less than or equal to about 10 nm, less than or equal to about 9 nm, less than or equal to about 8.5 nm, less than or equal to about 8 nm, less than or equal to about 7.5 nm, or less than or equal to about 7 nm.

The size or average size (hereinafter referred to as "size") of the zinc-containing oxide nanoparticles according to an embodiment may be greater than or equal to about 1 nm, greater than or equal to about 2 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, or greater than or equal to about 7 nm, and the average size of the zinc-containing oxide nanoparticles may be less than or equal to about 30 nm, for example less than or equal to about 25 nm, less than or equal to about 20 nm, less than or equal to about 15 nm, less than or equal to about 10 nm, less than or equal to about 9 nm, less than or equal to about 8 nm, less than or equal to about 7 nm, or less than or equal to about 6 nm, but are not limited to these ranges.

In an embodiment, the thickness of the electron transport layer may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm, and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

In an embodiment, an electron injection layer may further be disposed between the electron transport layer and the second electrode. The material of the electron injection layer is not particularly limited and can be appropriately selected.

The electroluminescent diode according to an embodiment may further include a hole auxiliary layer. The hole auxiliary layer 2 or 20 may be located between the first electrode 1 or 10 and the light emitting layer 3 or 30. The hole auxiliary layer 2 or 20 may include a hole injection layer, a hole transport layer, and/or an electron blocking layer. The hole auxiliary layer 12 may be a single-component layer or a multilayer structure in which adjacent layers include different components.

The hole auxiliary layer 2 or 20 may have a HOMO energy level that can be matched with the HOMO energy level of the light emitting layer 3 or 30 to enhance the mobility of holes transferred from the hole auxiliary layer to the light emitting layer 3 or 30. In an embodiment, the hole auxiliary layer 2 or 20 may include a hole injection layer close to the first electrode 1 or 10 and a hole transport layer close to the light emitting layer 3 or 30.

The material included in the hole auxiliary layer 2 or 20 (e.g., the hole transport layer, the hole injection layer, or the electron blocking layer) is not particularly limited, and may include, for example, poly(9,9-dioctyl-fluorene-co-N-(4)-butylphenyl)-diphenylamine) (TFB), polyarylamine, poly(N-vinylcarbazole), poly(3,4-ethylenedioxythiophene) (PEDOT), poly(3,4-ethylenedioxythiophene) polystyrene sulfonate (PEDOT:PSS), polyaniline, polypyrrole, N,N,N',N'-tetrakis(4-methoxyphenyl)-benzidine (TPD), 4,4'-bis[N-(1-naphthyl)-N-phenyl-amino]biphenyl (alpha-NPD), m-MTDATA (4,4',4"-Tris[phenyl(m-tolyl)amino]triphenylamine), 4,4',4"-tris(N-carbazolyl)-triphenylamine (TCTA), 1,1-bis[(di-4-toylamino)phenylcyclohexane (TAPC), a p-type metal oxide (e.g., NiO, WO₃, MoO₃, or the like), a carbon-containing material, such as graphene oxide, or a combination thereof, but is not limited thereto.

In the hole auxiliary layer(s), the thickness of each layer may be appropriately selected. For example, the thickness of each layer may be greater than or equal to about 5 nm, greater than or equal to about 10 nm, greater than or equal to about 15 nm, or greater than or equal to about 20 nm, and the thickness of each layer may be less than or equal to about 100 nm, less than or equal to about 90 nm, less than or equal to about 80 nm, less than or equal to about 70 nm, less than or equal to about 60 nm, less than or equal to about 50 nm, for example, less than or equal to about 40 nm, less than or equal to about 35 nm, or less than or equal to about 30 nm, but is not limited thereto.

A device according to an embodiment may have a normal structure. In an embodiment, in the device, the anode 10 disposed on the transparent substrate 100 may include a metal oxide-containing transparent electrode (e.g., an ITO electrode), and the cathode 50 facing the anode 10 may include a conductive metal (e.g., having a relatively low work function, such as Mg, Al, or the like). The hole auxiliary layer 20 (e.g., a hole injection layer such as PEDOT:PSS and/or p-type metal oxide and/or a hole transport layer, such as TFB and/or polyvinylcarbazole (PVK)) may be provided between the transparent electrode 10 and the light emitting layer 30. The hole injection layer may be close to the transparent electrode, and the hole transport layer may be close to the light emitting layer. An electron auxiliary layer 40 may be disposed between the light emitting layer 30 and the cathode 50.

A device according to another embodiment may have an inverted structure. Herein, the cathode 50 disposed on the transparent substrate 100 may include a transparent electrode based on a metal oxide (e.g., ITO), and the anode 10 facing the cathode 50 may include a metal (e.g., Au, Ag, or the like) (having a relatively high work function). For example, an n-type metal oxide (e.g., crystalline Zn metal oxide) (optionally doped) may be disposed between the transparent electrode 50 and the light emitting layer 30 as an electron auxiliary layer (e.g., electron transport layer) 40. Between the metal anode 10 and the light emitting layer 30, MoO₃ or another p-type metal oxide can be disposed as a hole auxiliary layer (e.g., a hole transport layer including TFB and/or PVK and/or a hole injection layer including MoO₃ or another p-type metal oxide) 20.

The above-mentioned devices can be manufactured by an appropriate method. For example, the electroluminescent diode may be manufactured by optionally forming a hole auxiliary layer (e.g., by deposition or coating) on a substrate on which electrodes are formed, forming a light emitting layer including semiconductor nanoparticles (e.g., a pattern of the semiconductor nanoparticles described above), and forming an electron transport layer and an electrode on the light emitting layer (e.g., by deposition or coating). The method of forming the electrode/hole auxiliary layer/electron auxiliary layer may be appropriately selected and is not particularly limited.

The electroluminescent diode of an embodiment may exhibit improved electroluminescent properties, for example, along with a longer life-span as described above.

The electroluminescent diode of an embodiment can have a maximum external quantum efficiency (EQE Max) of greater than or equal to about 5%, greater than or equal to about 5.5%, greater than or equal to about 6%, greater than or equal to about 6.5%, greater than or equal to about 7%, greater than or equal to about 7.5%, greater than or equal to about 7.7%, greater than or equal to about 8%, greater than or equal to about 8.5%, greater than or equal to about 9%, greater than or equal to about 9.5%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. The light emitting layer may have a maximum external quantum efficiency (EQE Max) of less than or equal to about 40%, less than or equal to about 30%, or less than or equal to about 20%.

The electroluminescent diode may have a maximum luminance (LUM Max) of greater than or equal to about 50,000 candela per square meter (cd/m²), greater than or equal to about 60,000 cd/m², greater than or equal to about 70,000 cd/m², greater than or equal to about 80,000 cd/m², greater than or equal to about 90,000 cd/m², greater than or equal to about 100,000 cd/m², greater than or equal to about 150,000 cd/m², greater than or equal to about 200,000 cd/m², greater than or equal to about 250,000 cd/m², greater than or equal to about 300,000 cd/m², greater than or equal to about 310,000 cd/m², greater than or equal to about 320,000 cd/m², greater than or equal to about 330,000 cd/m², greater than or equal to about 340,000 cd/m², greater than or equal to about 350,000 cd/m², greater than or equal to about 360,000 cd/m², greater than or equal to about 370,000 cd/m², greater than or equal to about 380,000 cd/m², greater than or equal to about 390,000 cd/m², greater than or equal to about 400,000 cd/m², greater than or equal to about 440,000 cd/m², greater than or equal to about 500,000 cd/m², or greater than or equal to about 550,000 cd/m². The maximum luminance of the light emitting layer in the luminescent diode or display device may be less than or equal to about 1,000,000 cd/m², or less than or equal to about 600,000 cd/m².

The electroluminescent diode may be configured to emit blue light, green light, or red light. The peak emission wavelengths of the blue light, the green light, and the red light are as described herein.

Additionally, the electroluminescent diode of an embodiment may have a T50 of greater than or equal to about 100 hours, greater than or equal to about 150 hours, greater than or equal to about 200 hours, greater than or equal to about 250 hours, greater than or equal to about 300 hours, greater than or equal to about 350 hours, greater than or equal to about 400 hours, greater than or equal to about 500 hours, greater than or equal to about 600 hours, or greater than or equal to about 700 hours when driven at a predetermined luminance (e.g., 650 nits). The T50 may be about 270 hours to about 4000 hours, about 270 hours to about 2000 hours, about 280 hours to about 1500 hours, about 300 hours to about 1000 hours, or about 300 hours to about 900 hours.

The electroluminescent diode may have a T90 of greater than or equal to about 10 hours, greater than or equal to about 20 hours, greater than or equal to about 30 hours, greater than or equal to about 40 hours, greater than or equal to about 50 hours, greater than or equal to about 60 hours, greater than or equal to about 70 hours, greater than or equal to about 80 hours, greater than or equal to about 90 hours, greater than or equal to about 100 hours, greater than or equal to about 110 hours, greater than or equal to about 120 hours, greater than or equal to about 130 hours, greater than or equal to about 140 hours, greater than or equal to about 150 hours, greater than or equal to about 160 hours, greater than or equal to about 170 hours, greater than or equal to about 180 hours, greater than or equal to about 190 hours, or greater than or equal to about 200 hours (when driven at a predetermined luminance, for example, 650 nits). The electroluminescent diode may have a T90 of about 10 hours to about 1000 hours, about 15 hours to about 1000 hours, about 15 hours to about 800 hours, about 20 hours to about 700 hours, or a combination thereof (when driven at a predetermined luminance, e.g., 650 nits).

The electroluminescent diode may have an initial voltage of less than or equal to about 3 volts, for example, less than or equal to about 2.9 volts, or less than or equal to about 2.88 volts (when driven at a predetermined luminance, for example, 650 nits). The initial voltage may be 2 greater than or equal to about 2.5 volts, greater than or equal to about 2.6 volts, or greater than or equal to about 2.7 volts.

Another embodiment relates to a display device including the aforementioned electroluminescent diode.

The display device may include a first pixel and a second pixel configured to emit light of a color differing from that of the first pixel. In the first pixel, the second pixel, or a combination thereof, the electroluminescent diode according to an embodiment may be disposed. In an embodiment, the display device may further include a blue pixel, a red pixel, a green pixel, or a combination thereof. In the display device, the red pixel may include a red light emitting layer including a plurality of red light emitting semiconductor nanoparticles, the green pixel may include a green light emitting layer including a plurality of green light emitting semiconductor nanoparticles, and the blue pixel may include a blue light emitting layer including a plurality of blue light emitting semiconductor nanoparticles.

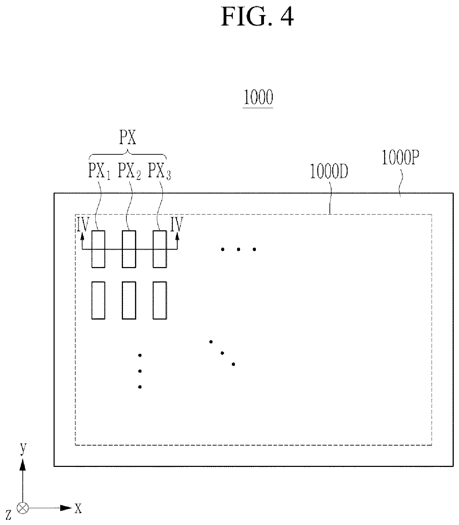

Referring to FIG. 4, a display panel 1000 according to an embodiment may include a display area 1000D for displaying an image and, optionally, a non-display area 1000P disposed around the display area 1000D and in which a binding element (not shown) may be disposed. The display area 1000D may include a plurality of pixels PXs arranged along a row (e.g., x direction) and/or a column (e.g., y direction), and each pixel PX may include a plurality of subpixels PX₁, PX₂, and PX₃ displaying different colors. Herein, as an example, a configuration in which three subpixels PX₁, PX₂, and PX₃ constitute one pixel PX is illustrated, but the configuration is not limited thereto. An additional subpixel, such as a white subpixel, may be further included, and one or more subpixel displaying the same color may be included. The plurality of pixels PXs may be arranged in, for example, a Bayer matrix, a PenTile matrix, and/or a diamond matrix, but is not limited thereto.

Each of the subpixels PX₁, PX₂, and PX₃ may be configured to display a color of three primary colors or a combination of three primary colors, for example, red, green, blue, or a combination thereof. For example, the first subpixel PX₁ may be configured to display red, the second subpixel PX₂ may be configured to display green, and the third subpixel PX₃ may be configured to display blue.

In FIG. 4, an example in which all subpixels have the same size is illustrated, but the present disclosure is not limited thereto. At least one of the subpixels may be larger or smaller than the other subpixels. In FIG. 4, an example in which all subpixels have the same shape is illustrated, but the present disclosure is not limited thereto. At least one of the subpixels may have a different shape from other subpixels.

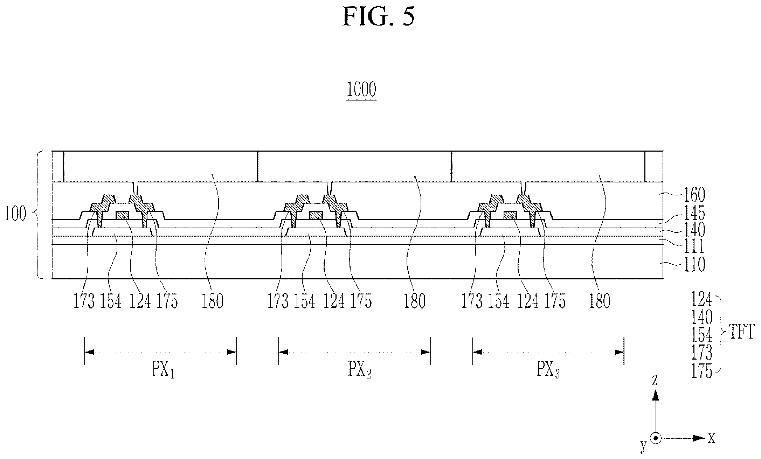

Referring to FIG. 5, in an embodiment, the display panel may include a substrate 110, a buffer layer 111, a thin film transistor TFT, and a luminescent diode 180. The display panel may include circuit elements configured to switch and/or drive each luminescent device.

The luminescent diodes 180 may be arranged in each subpixel PX1, PX2, and PX3, and the luminescent diodes 180 arranged in the subpixel PX1, PX2, and PX3 may each independently be driven. The subpixel may include a blue pixel, a red pixel, or a green pixel. At least one of the luminescent diodes 180 may be an electroluminescent diode according to an embodiment.

The substrate 110 is as described above. The buffer layer 111 may include an organic material, an inorganic material, or an organic-inorganic material. The buffer layer 111 may include, for example, an oxide, a nitride, or an oxynitride, and may include, for example, silicon oxide, silicon nitride, silicon oxynitride, or a combination thereof, but is not limited thereto. The buffer layer 111 may be one layer or two or more layers, and may cover the whole surface of the lower substrate 110. The buffer layer 111 may be omitted.

The thin film transistor TFT may be a three terminal element for switching and/or driving the luminescent diode 180, and one or two or more may be included for each subpixel. The thin film transistor TFT may include a gate electrode 124, a semiconductor layer 154 overlapped with the gate electrode 124, a gate insulating layer 140 between the gate electrode 124 and the semiconductor layer 154, and a source electrode 173 and a drain electrode 175 electrically connected to the semiconductor layer 154. In FIG. 5, a coplanar top gate structure is shown as an example, but the structure is not limited thereto and may have various structures.

The gate electrode 124 may be electrically connected to a gate line (not shown), and may include, for example, a low-resistance metal such as aluminum (Al), molybdenum (Mo), copper (Cu), titanium (Ti), silver (Ag), gold (Au), an alloy thereof, or a combination thereof, but is not limited thereto.

The semiconductor layer 154 may be an inorganic semiconductor, such as amorphous silicon, polycrystalline silicon, or oxide semiconductor; an organic semiconductor; an organic-inorganic semiconductor; or a combination thereof. For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but they are not limited thereto. The semiconductor layer 154 may include a channel region and doped regions disposed on both sides of the channel region and electrically connected to the source electrode 173 and the drain electrode 175, respectively.

The gate insulating layer 140 may include an organic material, an inorganic material, or an organic-inorganic material, and may include, for example, an oxide, a nitride, or an oxynitride, and may include, for example, silicon oxide, silicon nitride, silicon oxynitride, or a combination thereof, but is not limited thereto. In FIG. 5, an example in which the gate insulating layer 140 is formed on the whole surface of the lower substrate 110 is illustrated, but the present disclosure is not limited thereto and the gate insulating layer 140 may be optionally formed between the gate electrode 124 and the semiconductor layer 154. The gate insulating layer 140 may be formed of one or two or more layers.

The source electrode 173 and the drain electrode 175 may include, for example, a low-resistance metal, such as aluminum (Al), molybdenum (Mo), copper (Cu), titanium (Ti), silver (Ag), gold (Au), an alloy thereof, or a combination thereof, but are not limited thereto. The source electrode 173 and the drain electrode 175 may be electrically connected to the doped regions of the semiconductor layer 154, respectively. The source electrode 173 may be electrically connected to a data line (not shown), and the drain electrode 175 may be electrically connected to a luminescent diode 180 described above.

An interlayer insulating layer 145 may be additionally formed between the gate electrode 124 and the source/drain electrodes 173 and 175. The interlayer insulating layer 145 may include an organic material, an inorganic material, or an organic-inorganic material, for example, oxide, nitride, or oxynitride, for example, silicon oxide, silicon nitride, silicon oxynitride, or a combination thereof, but is not limited thereto. The interlayer insulating layer 145 may be formed of one or two or more layers.

In an embodiment, a protective film 160 may be formed on the thin film transistor TFT. The protective film 160 may be, for example, a passivation layer, but is not limited thereto. The protective film 160 may include an organic material, an inorganic material, or an organic-inorganic material, for example, polyacrylic, polyimide, polyamide, polyamideimide, or a combination thereof, but is not limited thereto. The protective film 160 may be formed of one or two or more layers.

In an embodiment, one of the first electrodes 1 and 10 and the second electrodes 5 and 50 may be a pixel electrode connected to the TFT, and the other may be a common electrode.

The display device of an embodiment may be used as a top emission type display panel, a bottom emission type display panel, or a both side emission type display panel.

In an embodiment, the first electrodes 1 and 10 may be a light-transmitting electrode and the second electrode 5 and 50 may be a reflecting electrode, and the display panel may be a bottom emission type display panel that emits light toward the first electrodes 1 and 10 and, if present, the substrate 110. In an embodiment, the first electrodes 1 and 10 may be reflecting electrodes and the second electrode 5 and 50 may be a light-transmitting electrode, and the display panel may be a top emission type display panel that emits light to the opposite side of the first electrodes 1 and 10 and, if present, the substrate 100. In an embodiment, both the first electrode and the second electrode may be light-transmitting electrodes, and the display panel 1000 may be a both side emission type display panel that emits light to a side of the substrate 110 and to a side opposite to the substrate 110.

The display device may include a portable terminal device, a monitor (e.g., portable monitor), a notebook computer, a television, an electric sign board, a camera, or an electronic component.

Specific examples are described below. However, the examples described below are only for specifically illustrating or explaining the disclosure, and the scope of the disclosure is not limited thereto.

### Examples

### Analysis Method

### [1] Electroluminescence Spectroscopic Analysis

A current according to a voltage is measured with a Keithley 2635B source meter, while the voltage is applied, and a CS2000 spectrometer is used to measure EL properties (e.g., luminance and EQE, or the like).

### [2] Life-span Characteristics

T90(h): When starting operation at a given initial luminance (e.g., 650 nit), it measures the time (hr) it takes for the luminance to reach 90% of the initial luminance (100%).

T50(h): When starting operation at a given initial luminance (e.g., 650 nit), the time (hr) taken for the luminance to reach 50% of the initial luminance of 100% is measured.

### [3] XPS Analysis

XPS analysis is performed using X-ray photoelectron spectroscopy (Manufacturer: Physical Electronics, Model: Quantum2000).

### [4] ICP-AES Analysis

Inductively coupled plasma atomic emission spectrometry (ICP-AES) was performed using a Shimadzu ICPS-8100.

### [5] TEM Analysis

A transmission electron microscope analysis of the prepared nanoparticles is performed by using an UT F30 Tecnai electron microscope.

### [6] Photoluminescence Analysis

Photoluminescence (PL) analysis is performed by using a Hitachi F-7100 spectrophotometer.

### [7] UV-Vis Spectroscopy

UV spectral analysis is performed using a Shimadzu UV-2600 spectrometer to obtain UV-Visible absorption spectra. The band gap energy (eV) may be obtained from the X-intercept wavelength (nm) of the obtained UV-Visible absorption spectrum using the following equation:
Band gap energy (eV) = 1240 (nm)/ X-intercept wavelength (nm)

### [8] Thermogravimetric analysis (TGA) Analysis

TGA analysis is performed under N₂ atmosphere using a Trios V3.2 system (TA Instruments) at a heating rate of 10 °C/min from 20 to 600 °C.

### [9] Dynamic Light Scattering (DLS) Analysis

DLS analysis is performed using Otsuka, ELSZ-2000.

The following synthesis is performed under an inert gas atmosphere (under a nitrogen flowing condition), unless otherwise specified. A precursor content is a mole content, unless otherwise specified.

### Synthesis Example 1: Preparation of blue light-emitting ZnSeTe/ZnSeS quantum dot

A S/TOP stock solution, a Se/TOP stock solution and a Te/TOP stock solution are prepared by respectively dispersing sulfur (S), selenium (Se) and tellurium (Te) in trioctylphosphine (TOP). To a reactor including trioctylamine, 0.125 millimole (mmol) of zinc acetate with oleylamine and oleic acid is added, and then, heated at 120 °C under vacuum. After 1 hour, an atmosphere in the reactor is substituted with nitrogen.

The reactor is heated to 240 °C, and the Se/TOP stock solution and the Te/TOP stock solution in a Te/Se molar ratio of 1/15 are rapidly injected into the reactor. When the reaction is completed, the reaction mixture is rapidly cooled to room temperature, acetone is added, and the resulting precipitate is separated by centrifuge and dispersed in toluene to obtain a dispersion of ZnSeTe core.

1.8 mmol of zinc acetate with oleic acid is added to a flask including trioctylamine, and then, vacuum-treated at 120 °C for 10 minutes. About an atmosphere of nitrogen (N₂) is introduced into the flask, which is then heated to 220 °C. Subsequently, the obtained ZnSeTe core is added to the flask, and Se/TOP and S/TOP are also injected into the flask. A reaction temperature is set to about 280 °C. Optionally, precursors may be additionally injected at the reaction temperature. When the reaction is completed, the reactor is cooled to room temperature, ethanol is added and the prepared nanocrystals are separated by centrifuge, and then, dispersed in toluene to obtain a dispersion of blue light emitting ZnSeTe/ZnSeS semiconductor nanoparticles.

Through a photoluminescence analysis, the semiconductor nanoparticles exhibit a maximum emission peak wavelength of 460 nm.

### Preparation of Zinc-containing Oxide Nanoparticles

### Preparation Example 1: Preparation of zinc magnesium oxide nanoparticles having metavanadate (VO₃⁻) disposed on a surface of the nanoparticles

Potassium hydroxide (KOH) is dissolved in ethanol at a concentration of 0.5 mole (M). 14.7 milliliters (ml) of the solution is mixed with 0.5 mmol of potassium metavanadate (KVO₃, Cas number: 13769-43-2) to prepare a first solution.

Zinc acetate dihydrate (powder), which is a zinc precursor, and magnesium acetate tetrahydrate (powder), which is a magnesium precursor, are dissolved in dimethylsulfoxide in a flask, and then, heated to 50 °C and maintained for 5 minutes to prepare a second solution. The zinc precursor and the magnesium precursor in the second solution have a molar ratio of 0.85:0.15 between zinc and magnesium.

The first solution is mixed with the second solution at 50 °C, and then, stirred for 60 minutes, while maintaining the temperature at 50 °C. In the mixed solution, the amount of metavanadate (VO₃⁻) is equivalent to 10 moles per 100 moles of zinc. After the stirring is completed, the solution is centrifuged to separate a precipitate from the supernatant.

Subsequently, ethyl acetate is added to the separated supernatant to form additional precipitate, which are separated by centrifuge. The obtained collective precipitate (nanoparticles) are washed more than twice with ethyl acetate to obtain zinc magnesium oxide nanoparticles.

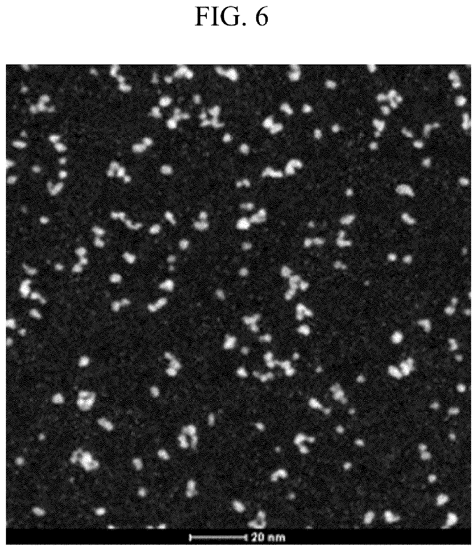

The obtained nanoparticles are redistributed/redispersed in ethanol, and then, subjected to transmission electron microscopy (TEM) analysis. As indicated, the nanoparticles have an average size of about 5 nm to about 10 nm (refer to FIG. 6).

### Preparation Example 2: Preparation of zinc magnesium oxide nanoparticles having metavanadate (VO₃⁻) disposed on a surface of the nanoparticles

Zinc magnesium oxide nanoparticles according to Preparation Example 2 are manufactured in a similar manner as in Preparation Example 1 except that the first solution is prepared by dissolving potassium hydroxide (KOH) in ethanol at a concentration of 0.4 M, and then, mixing 25 ml of the solution with 0.425 mmol of potassium metavanadate (KVO₃, CAS number: 13769-43-2).

### Preparation Example 3: Preparation of zinc magnesium oxide nanoparticles having metavanadate (VO₃⁻) disposed on a surface of the nanoparticles

Zinc magnesium oxide nanoparticles according to Preparation Example 3 are manufactured in a similar manner as in Preparation Example 1 except that the first solution is prepared by dissolving cesium hydroxide (CsOH) in ethanol at a concentration of 0.4 M, and then, mixing 25 ml of the solution with 0.425 mmol of potassium metavanadate (KVO₃, CAS number: 13769-43-2).

### Comparative Preparation Example 1: Preparation of zinc magnesium oxide nanoparticles

Zinc acetate dihydrate (powder), which is a zinc precursor, and magnesium acetate tetrahydrate (powder), which is a magnesium precursor, are added to a reaction flask, dissolved in dimethylsulfoxide, and then, heated to 50 °C and maintained at 50 °C for 5 minutes.

To the solution, 0.5 mmol of potassium metavanadate (KVO₃, CAS number: 13769-43-2) in powder form is added, and the mixture is stirred for 60 minutes at 50 °C.

In the solution, the zinc precursor and the magnesium precursor are mixed to include zinc and magnesium in a molar ratio of 0.85:0.15, respectively, and the amount of metavanadate (VO₃⁻) is equivalent to 10 moles based on 100 moles of zinc.

After the stirring is completed, the solution is centrifuged to separate and isolate the precipitate from the supernatant. Ethyl acetate is added to the separated supernatant to form additional precipitate, which are separated by centrifuge. The obtained nanoparticles are washed more than twice with ethyl acetate to obtain zinc magnesium oxide nanoparticles.

### Comparative Preparation Example 2: Preparation of zinc magnesium oxide nanoparticles

Tetramethylammonium hydroxide (N(CH₃)₄OH) is dissolved in ethanol at a concentration of 0.5 M to prepare a base solution.

A 0.1 M rubidium carbonate solution is prepared by dissolving rubidium carbonate (CAS number: 584-09-8) in ethanol.

A second solution is prepared by dissolving zinc acetate dihydrate (powder), which is a zinc precursor, and magnesium acetate tetrahydrate (powder), which is a magnesium precursor, in dimethylsulfoxide in a flask. In the second solution, the zinc precursor and the magnesium precursor are mixed to include zinc and magnesium in a molar ratio of 0.85:0.15, respectively.

The prepared base solution and the rubidium carbonate solution are added to the second solution, and then, stirred at room temperature for 60 minutes. In the mixed solution, the amount of rubidium carbonate is equivalent to 5 moles per 100 moles of zinc.

After the stirring is completed, ethyl acetate is added to the solution to form a precipitate, which are separated by centrifuge. The obtained particles are washed more than twice with ethyl acetate to obtain zinc magnesium oxide nanoparticles.

The obtained nanoparticles are redistributed in ethanol, and then, subjected to transmission electron microscope (TEM: Transmission Electron Microscopy) analysis. As indicated, the nanoparticles have an average size of about 3 nm to about 4.5 nm.

### Evaluation 1: Characterization of zinc magnesium oxide nanoparticles

### (1) XPS analysis results of nanoparticles of Preparation Example 1 and Comparative Preparation Example 1

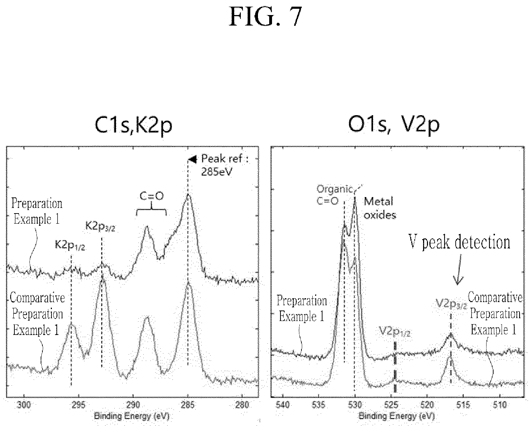

The zinc magnesium oxide nanoparticles synthesized in Preparation Example 1 and Comparative Preparation Example 1 are subjected to XPS analysis, and the results are shown in a graph of FIG. 7 and Table 1.

FIG. 7 is an intensity X-ray photoelectron spectroscopy (XPS) spectra showing binding energies of C1s, K2p (left graph) and O1s, V2p (right graph). Referring to an O1s peak in FIG. 7, the nanoparticles of Preparation Example 1 and Comparative Preparation Example 1 exhibit a metal oxide peak at the same position of 532 eV (affected by Zn-O and Mg-O bonds); however the nanoparticles of Preparation Example 1 exhibit a metal oxide peak with stronger intensity and also, a V2p peak with relatively stronger intensity than those of Comparative Preparation Example 1. In addition, referring to the left graph of FIG. 7, Comparative Preparation Example 1 exhibits a higher K2p peak induced from the KVO₃ powder added to introduce vanadate, but Preparation Example 1 exhibits a K2p peak with weaker intensity, and as shown in the right graph, V (vanadium) alone exhibits a large atomic %.

The XPS results are consistent with the data of Table 1. Referring to Table 1, Comparative Preparation Example 1 exhibits a large atomic content (atomic %) of K (potassium), whereas Preparation Example 1 exhibits a very small K atomic content. However, Preparation Example 1 exhibits a larger V atomic content than K atomic content. These results confirm that the surface of the zinc magnesium oxide nanoparticles is effectively passivated by vanadate ions in the method of Preparation Example 1, which may change an energy band of the nanoparticles, whereby, change their binding state in terms of the XPS data, as described later. On the other hand, the surface of the nanoparticles is confirmed to be not effectively passivated by adding the KVO₃ powder to the synthesized zinc magnesium nanoparticles of Comparative Preparation Example 1.

**Table 1**

| | C1s | O1s | Mg2p | Si2p | K2p | V2p3 | Zn2p3 |
|---|---|---|---|---|---|---|---|
| Comparative Preparation Example 1 | 21.54 | 47.09 | 2.15 | 6.82 | 3.06 | 4.22 | 15.13 |
| Preparation Example 1 | 20.37 | 45.99 | 2.77 | 2.14 | 0.08 | 3.64 | 25.00 |

In Table 1, the unit of each number is atomic %.

### (2) TEM-EDS analysis and mapping results of nanoparticles of Preparation Example 1

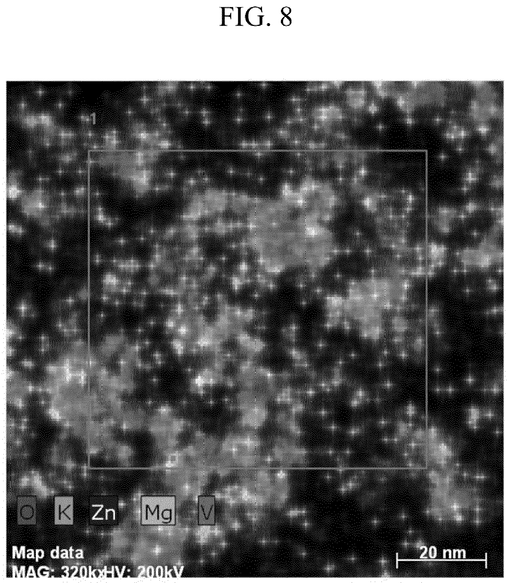

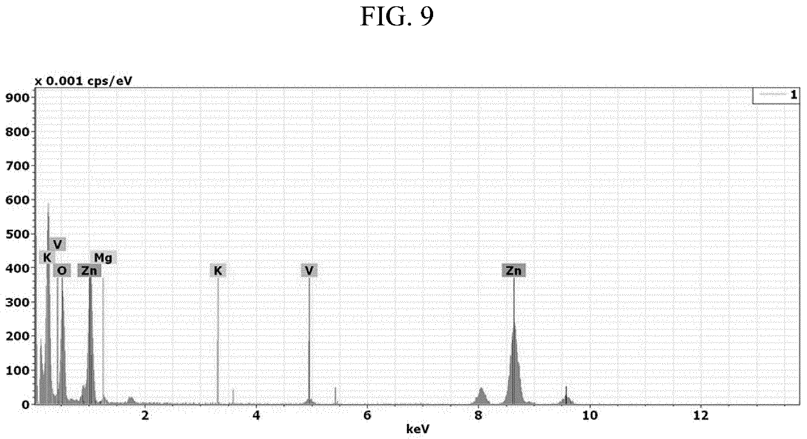

FIG. 8 is a TEM-EDS mapping image of zinc magnesium oxide nanoparticles of Preparation Example 1 having vanadate ions disposed on a surface of the nanoparticles, and FIG. 9 is a graph (plot) showing the TEM-EDS analysis results. Referring to the EDS mapping image of FIG. 8, it may be confirmed that zinc (Zn), magnesium (Mg), oxygen (O), and vanadium (V) elements are well overlapped, and the graph of FIG. 9 showing distinct peak intensity of the V element confirms that vanadate ions are well introduced on or proximate to a surface of the zinc magnesium oxide nanoparticles.

### (3) UV-Vis absorption spectroscopy and DLS analysis of nanoparticles of Preparation Examples 1 to 3 and Comparative Preparation Example 1

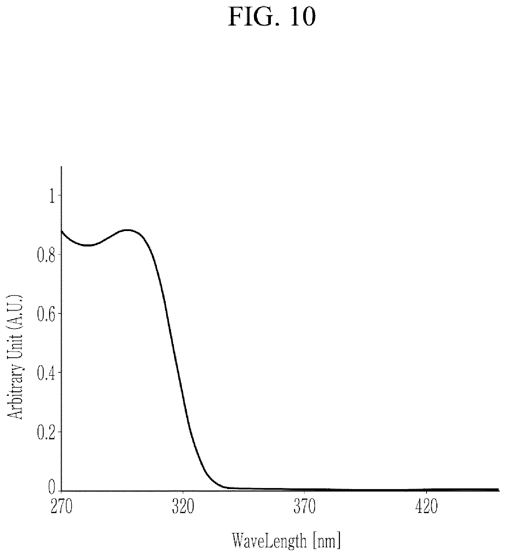

The nanoparticles according to Preparation Examples 1, 2, and 3 and Comparative Preparation Examples 1 are subjected to UV-Vis absorption spectroscopic analysis and DLS analysis, and the results are shown in FIGS. 10, 11, and 12 and Table 2.

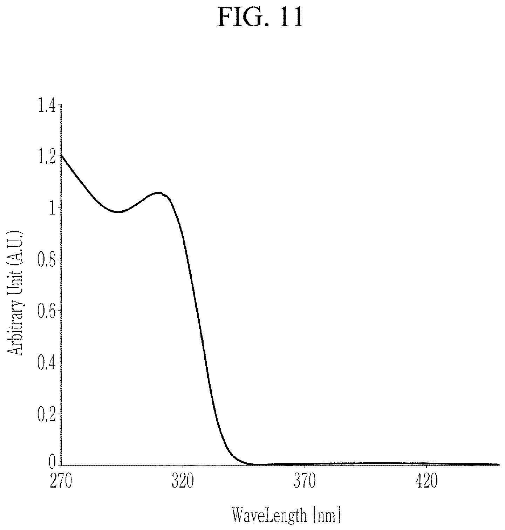

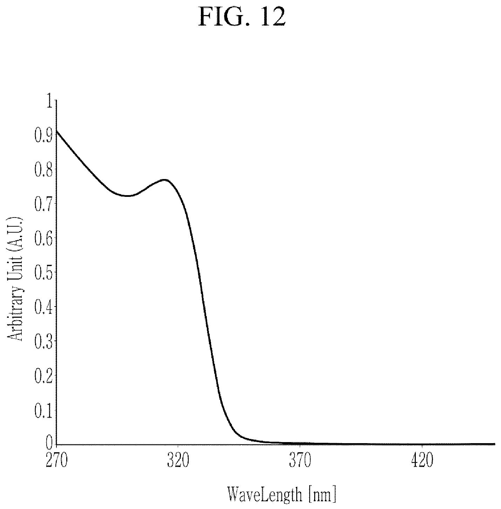

FIG. 10 is a UV-Vis absorption spectrum of nanoparticles prepared in Preparation Example 1, FIG. 11 is a UV-Vis absorption spectrum of nanoparticles prepared in Preparation Example 2, and FIG. 12 is a UV-Vis absorption spectrum of nanoparticles prepared in Preparation Example 3.

Referring to FIGS. 10, 11, and 12, in the UV-Vis absorption spectroscopic analysis of the nanoparticles of Preparation Examples 1, 2, and 3, respectively, a first absorption peak exists in a range of greater than or equal to about 285 nm and less than or equal to about 330 nm. In addition, it may be seen that there is a valley adjacent to the first absorption peak of each of the nanoparticles. The valleys have a valley depth (VD), which is defined by the following equation, in a range of greater than or equal to about 0.01 and less than or equal to about 0.2: $1 - \left({Abs}_{valley}/{Abs}_{first}\right) = VD$ wherein, in the above equation, Abs_{first} is an absorption at the first absorption peak, and Abs_{valley} is an absorption at the lowest point of the valley adjacent to the first absorption peak.

A first absorption peak (UV Peak), maximum absorption intensity (UV Max), and an x-intercept of each of the nanoparticles are measured from the UV-Vis absorption spectra of FIGS. 10, 11, and 12, and DLS average particle diameters of each of the nanoparticles are measured by the DLS analysis method, and the results are respectively shown in Table 2.

**Table 2**

| | UV Peak (nm) | UV Max (A.U.) | X intercept | DLS (nm) | Standard deviation (±) |
|---|---|---|---|---|---|
| Comparative Preparation Example 1 | 300 | 0.9220 | 331.2 | 7.7 | 4.4 |
| Preparation Example 1 | 298 | 0.883 | 327.0 | 4.7 | 1.8 |
| Preparation Example 2 | 310 | 1.058 | 336.8 | 5.6 | 2.28 |
| Preparation Example 3 | 313 | 0.769 | 340.2 | 7.1 | 2.4 |

### Manufacturing of electroluminescent diodes

### Example 1 and Comparative Example 1

The semiconductor nanoparticles of Synthesis Example 1 are dispersed in octane to prepare a semiconductor nanoparticle solution. The zinc oxide nanoparticles of Preparation Example 1 are dispersed in ethanol to prepare a dispersion for an electron transport layer (ETL).

An electroluminescent diode (ITO/PEDOT (35 nm)/TFB (25 nm)/QD light emitting layer (20 nm)/ETL (20 nm)/Al (100 nm)) is manufactured according to the following method:

A glass substrate deposited with ITO is surface treated with UV-ozone for 15 minutes, and a PEDOT:PSS solution (H.C. Starks) is spin-coated on the surface-treated glass substrate. Then, the spin-coated glass substrate is heat-treated at 150 °C for 10 minutes under an air atmosphere, and reheat treated at 150 °C for 20 minutes to 30 minutes under a N₂ atmosphere to form a 35 nm-thick hole injection layer.

A poly[(9,9-dioctylfluoren-2,7-diyl-co-(4,4'-(N-4-butylphenyl)diphenylamine] (TFB) (Sumitomo Corp.) solution is spin-coated on the hole injection layer, and then, the spin-coated hole injection layer is heat-treated at 150 °C for 30 minutes to form a 25 nm-thick hole transport layer.

The prepared semiconductor nanoparticle solution is spin-coated on the hole transport layer to form a 20 nm-thick light emitting layer.

A solution of Rb₂CO₃ in ethanol (EtOH) is added to the prepared ETL dispersion and spin-coated on the light emitting layer, and then, washed with a mixed solution of citric acid and acetic acid in a ratio of 3:1 and dried. Subsequently, a heat treatment is performed for 30 minutes to form an electron transport layer (thickness:20 nm).

Aluminum (Al) is vacuum-deposited on the electron transport layer to form a 100 nm-thick second electrode, manufacturing an electroluminescent diode according to Example 1.

On the other hand, an electroluminescent diode according to Comparative Example 1 is manufactured in the similar manner as above except that the ETL dispersion is prepared by dispersing the zinc magnesium oxide nanoparticles of Comparative Preparation Example 1 in ethanol.

The electroluminescent diodes according to Example 1 and Comparative Example 1 are measured with respect to electroluminescence properties and life-span, and the results are shown in Table 3.

**Table 3**

| | EQE Max (%) | Lum Max (nit) | EQE@ 5000 nit | EQE@ 10000 nit | EQE@ 20000 nit | Cd/A Max | T90 (h) | T50 (h) | Curr. (mA) | Init. V (V) | V@ T50 (V) |
|---|---|---|---|---|---|---|---|---|---|---|---|
| Comp. Ex. 1 | 5.3 | 67556 | 5.0 | 4.4 | 3.7 | 7.4 | 81.7 | 156.5 | 0.19 | 2.87 | 4.62 |
| Ex. 1 | 12.0 | 103703 | 12.0 | 11.3 | 10.2 | 15.3 | 52.9 | 306.0 | 0.10 | 2.86 | 3.74 |

In Table 3, Init. V indicates initial driving voltage.

As shown in Table 3, the device of Comparative Example 1 exhibits maximum external quantum efficiency (EQE Max) of 5.3%, but the device of Example 1 exhibits maximum external quantum efficiency (EQE Max) of 12.0%, which is more than 2-times greater. In addition, the maximum luminance (Lum. Max) of the device of Example 1 is nearly 2-times greater than that of Comparative Example 1. In addition, the device of Example 1 exhibits an EQE that is more than 2-times greater than that of Comparative Example 1 within the entire luminance range of 5,000 to 20,000 nit. Example 1 also exhibits more than 2-times greater maximum luminance per current (Cd/A Max) than that of Comparative Example 1.

In terms of life-span, although the device of Comparative Example 1 exhibits longer T90 than that of Example 1, T50 of the device of Example 1 is nearly twice (2-times greater) than that of Comparative Example 1. This indicates that although the device of Example 1 exhibits a shorter time for luminance to decrease by 10% than that of Comparative Example 1, the decrease in luminance of the device of Example 1 is less, i.e., more gradual thereafter, and therefore, the T50, i.e., the luminance to decrease by 50%, of Example 1 is much greater (longer) than that of Comparative Example 1.

Accordingly, the electroluminescent diode of Example 1 exhibits excellent properties and life-span over that of Comparative Example 1.

### Example 2 and Comparative Example 2

An electroluminescent diode according to Example 2 is manufactured in a similar manner as in Example 1 except that the electron transport layer (ETL) (thickness: 20 nm) is formed by dispersing the zinc oxide nanoparticles of Preparation Example 2 in ethanol to prepare a dispersion for an electron transport layer (ETL), spin-coating the ETL dispersion on the light emitting layer, and immediately heat-treating it for 30 minutes without adding the Rb₂CO₃ ethanol solution and the subsequent washing.

In addition, an electroluminescent diode according to Comparative Example 2 is manufactured in a similar manner as in Example 2 except that the ETL dispersion is prepared by dispersing the zinc magnesium oxide nanoparticles of Comparative Preparation Example 1 in ethanol.

The electroluminescent diode is measured with respect to electroluminescence properties and life-span measurements, and the results are listed in Table 4.

**Table 4**

| | EQE Max (%) | Lum Max (nit) | T90 (h) | T50 (h) | Curr. (mA) | Init. V (V) | V@T50 (V) | ΔV/hr (V/hr) |
|---|---|---|---|---|---|---|---|---|
| Comp. Ex. 2 | 9.7 | 91875 | 27.45 | 204.71 | 0.13 | 2.74 | 3.41 | 0.003 |
| Ex. 2 | 9.6 | 106710 | 36.94 | 259.40 | 0.12 | 2.71 | 3.26 | 0.002 |

In Table 4, T50 is a prediction based on a trend line, and ΔV/hr indicates change in voltage per hour.

As shown in Table 4, the devices of Example 2 and Comparative Example 2 exhibit similar maximum external quantum efficiency (EQE Max), but maximum luminance of the device of Example 2 is slightly higher (about 16% higher) than the device of Comparative Example 2. However, in terms of the life-span, the device of Example 2 exhibits much longer T90 and T50 than that of Comparative Example 2. In addition, a driving voltage at T50 is lower in the device of Example 2 than that of Comparative Example 2. In other words, the devices of Example 2 and Comparative Example 2 have some similar luminescent properties, but the device of Example 2 exhibits much greater life-span characteristics than that of Comparative Example 2.

### Example 3 and Comparative Example 3

An electroluminescent diode of Example 3 is manufactured in the same manner as in Example 1 except that the ETL dispersion is prepared by dispersing the zinc oxide nanoparticles of Preparation Example 2 in ethanol.

An electroluminescent diode of Comparative Example 3 is manufactured in the same manner as in Example 3 except that the ETL dispersion is prepared by dispersing the zinc magnesium oxide nanoparticles of Comparative Preparation Example 1 in ethanol.

The manufactured electroluminescent diodes are measured with respect to electroluminescence properties and life-span, and the results are shown in Table 5.

**Table 5**

| | EQE Max (%) | Lum Max (nit) | Cd/A Max | V @ 5 mA | Cd/m² @ 5 mA | V @ 1000 nt | EL Max @ 650 nit (nm) | FWHM (nm) | CIE x | CIE y |
|---|---|---|---|---|---|---|---|---|---|---|
| Comp. Ex. 3 | 6.6 | 87014 | 9.6 | 2.6 | 469.7 | 2.7 | 478 | 50 | 0.1212 | 0.2202 |
| Ex. 3 | 12.6 | 113405 | 14.7 | 2.7 | 672.2 | 2.8 | 472 | 48 | 0.1223 | 0.2030 |

EL Max@ 650 nit indicates the wavelength of maximum electroluminescence when the luminance is 650 nit.

As shown in Table 5, the device of Example 3 exhibits much higher EQE Max and Lum Max than that of Comparative Example 3. In particular, the device of Example 3 exhibits a EQE Max that is nearly 2-times greater than that of Comparative Example 3. Example 3 also exhibits much better maximum luminance per current (Cd/A) and luminance at a current of 5 mA than that of Comparative Example 3. In other words, the device of Example 3, as compared to that of Comparative Example 3, exhibits much better luminescence properties.

### Example 4 and Comparative Example 4

An electroluminescent diode of Example 4 is manufactured in the similar manner as in Example 2 except that the ETL dispersion is prepared by dispersing the zinc oxide nanoparticles of Preparation Example 3 in ethanol to form the electron transport layer (ETL).

An electroluminescent diode of Comparative Example 4 is manufactured in the same manner as in Example 4 except that the ETL dispersion is prepared by dispersing the zinc magnesium oxide nanoparticles of Comparative Preparation Example 1 in ethanol to form the electron transport layer (ETL).

The manufactured electroluminescent diodes are measured with respect to electroluminescence properties and life-span, and the results are shown in Table 6.

**Table 6**

| | EQE Max (%) | Lum Max (nit) | EQE @ 5000 nit | EQE @ 20000 nit | Cd/A Max | V@ 5 mA |
|---|---|---|---|---|---|---|
| Comp. Ex. 4 | 4.7 | 51428 | 4.4 | 3.2 | 6.8 | 2.8 |
| Ex. 4 | 7.3 | 93443 | 7.1 | 6.3 | 9.3 | 2.9 |

As shown in Table 6, the device of Example 4 exhibits an EQE Max and a Lum Max that are nearly 2-times greater than those of Comparative Example 4. In addition, the device of Example 4 exhibits much higher EQE at both of 5,000 nit and 20,000 nit, and also, much higher maximum luminance per current (Cd/A) than that of Comparative Example 4. In other words, the device of Example 4 exhibits much better luminescence properties than those of Comparative Example 4.

### Example 5 and Comparative Example 5

The semiconductor nanoparticles of Synthesis Example 1 are dispersed in octane to prepare a semiconductor nanoparticle solution. The zinc oxide nanoparticles of Preparation Example 3 are dispersed in ethanol to prepare a dispersion for an electron transport layer (ETL).

According to the following method, an electroluminescent diode (ITO/PEDOT (35 nm)/TFB (25 nm)/QD light emitting layer (28 nm)/ETL (20 nm)/Al (100 nm)) is manufactured:
After surface-treating a glass substrate deposited with ITO with UV-ozone for 15 minutes, a PEDOT:PSS solution (H.C. Starks) is spin-coated on the surface-treated glass substrate, and heat-treated at 150 °C for 10 minutes under an air atmosphere, and then, reheat-treated at 150 °C for 20 minutes to 30 minutes under a N₂ atmosphere to form a 35 nm-thick hole injection layer.

A poly[(9,9-dioctylfluoren-2,7-diyl-co-(4,4'-(N-4-butylphenyl)diphenylamine] (TFB) (Sumitomo Corp.) solution is spin-coated on the hole injection layer, and then, the spin-coated hole injection layer is heat-treated at 150 °C for 30 minutes to form a 25 nm-thick hole transport layer.

The prepared semiconductor nanoparticle solution is spin-coated on the hole transport layer to form a 28 nm-thick light emitting layer.

The ETL dispersion is spin-coated on the light emitting layer, and then, heat-treated for 30 minutes to form an electron transport layer (thickness: 20 nm).

Aluminum (Al) is vacuum-deposited on the electron auxiliary layer to form a 100 nm-thick second electrode, manufacturing an electroluminescent diode according to Example 5.

The electroluminescent diode of Comparative Example 5 is manufactured in the similar manner as in Example 5 except that the ETL dispersion is prepared by dispersing the zinc magnesium oxide nanoparticles of Comparative Preparation Example 1 in ethanol.

**Table 7**

| | EQE Max (%) | Lum Max (nit) | V @ 5 mA (V) | T90 (h) | T50 (h) |
|---|---|---|---|---|---|
| Comp. Ex. 5 | 11.5 | 92648 | 2.74 | 19.4 | 124.6 |
| Ex. 5 | 10.5 | 99356 | 2.82 | 24.3 | 140.0 |

As shown in Table 7, the devices of Example 5 and Comparative Example 5 exhibit similar EQE Max and Lum Max, but the device of Example 5 exhibits greater (or improved) T90 and T50 life-spans than that of Comparative Example 5. In other words, the device of Example 5, compared with that of Comparative Example 5, exhibits excellent life-span characteristics.

### Example 6 and Comparative Example 6

The semiconductor nanoparticles of Synthesis Example 1 are dispersed in octane to prepare a semiconductor nanoparticle solution. The zinc oxide nanoparticles of Preparation Example 3 are dispersed in ethanol to prepare a dispersion for an electron transport layer (ETL).

According to the following method, an electroluminescent diode (ITO/PEDOT (35 nm)/TFB (25 nm)/QD light emitting layer (20 nm)/ETL (20 nm)/Al (100 nm)) is manufactured:
After surface-treating a glass substrate deposited with ITO with UV-ozone for 15 minutes, a PEDOT:PSS solution (H.C. Starks) is spin-coated on the surface-treated glass substrate. Then, the spin-coated glass substrate is heat-treated at 150 °C for 10 minutes under an air atmosphere, and then reheat-treated at 150 °C for 20 minutes to 30 minutes under a N₂ atmosphere to form a 35 nm-thick hole injection layer.

A poly[(9,9-dioctylfluoren-2,7-diyl-co-(4,4'-(N-4-butylphenyl)diphenylamine] (TFB) (Sumitomo Corp.) solution is spin-coated on the hole injection layer, and then, the spin-coated hole injection layer is heat-treated at 150 °C for 30 minutes to form a 25 nm-thick hole transport layer.

The prepared semiconductor nanoparticle solution is spin-coated on the obtained hole transport layer to form a 20 nm-thick light emitting layer.

After adding a solution of Rb₂CO₃ in EtOH to the ETL dispersion, the mixture is spin-coated on the light emitting layer, and then, the spin-coated light emitting layer is washed with a mixed solution of citric acid and acetic acid in a ratio of 3:1 and dried. Subsequently, a heat treatment is performed for 30 minutes to from an electron transport layer (thickness: 20 nm).

Aluminum (Al) is vacuum-deposited on the obtained electron transport layer to form a 100 nm-thick second electrode, manufacturing an electroluminescent diode according to Example 6.

The electroluminescent diode of Comparative Example 6 is manufactured in the similar manner as in Example 6 except that the ETL dispersion is prepared by dispersing the zinc magnesium oxide nanoparticles of Comparative Preparation Example 1 in ethanol.

**Table 8**

| | EQE Max (%) | Lum Max (nit) | EQE@ 5000 nit | EQE@ 10000 nit | EQE@ 20000 nit | Cd/A Max | Cd/m² @ 5mA |
|---|---|---|---|---|---|---|---|
| Comp. Ex. 6 | 5.3 | 70618 | 5.2 | 4.9 | 4.1 | 7.0 | 331.5 |
| Ex. 6 | 7.7 | 88231 | 7.3 | 7.4 | 6.6 | 9.7 | 370.6 |

**Table 9**

| | T90 (h) | T50 (h) | Curr (mA) | Init. V (V) | V @ T50(V) | ΔV/hr (V/hr) |
|---|---|---|---|---|---|---|
| Comp. Ex. 6 | 45.89 | 126.92 | 0.20 | 3.06 | 4.44 | 0.010 |
| Ex. 6 | 52.03 | 150.14 | 0.16 | 3.04 | 4.19 | 0.008 |

As shown in Table 8, the device of Example 6 exhibits all excellent EQE Max and Lum Max, and excellent EQE in the luminance ranges of 5000 nit to 20000 nit and luminance at a current of 5 milliampere (mA) than that of Comparative Example 6. In other words, the device of Example 6, compared with the device of Comparative Example 6, exhibits more excellent device performance.

In addition, as shown in Table 9, the device of Example 6 exhibits longer T90 and T50 life-spans, a lower driving voltage at T50, and a smaller voltage change per time (ΔV/hr) than that of Comparative Example 6 and also. In other words, the device of Example 6 exhibits more excellent life-span characteristics than that of Comparative Example 6. In summary, the device of Example 6 exhibits more excellent device performance and life-span characteristics than that of Comparative Example 6.

### Evaluation 2: Calculation and diagramming of energy band arrangement of electroluminescent diodes

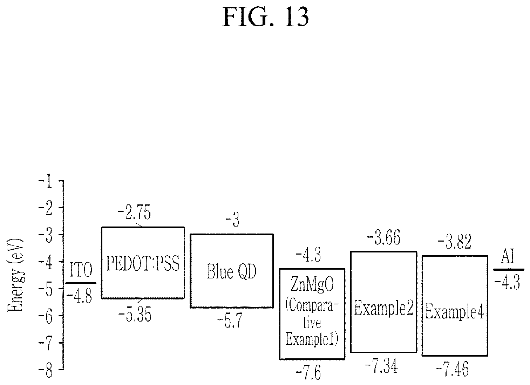

The energy band arrangements calculated from UPS (Ultraviolet Photoelectron Spectroscopy) measurement results of the devices of Comparative Example 1 and Examples 2 and 4 are shown in FIG. 13.

As shown in FIG. 13, when the nanoparticles according to an embodiment, which are prepared by arranging vanadium oxo anions (vanadate ions) on a surface of the zinc-containing oxide nanoparticles, and the nanoparticles according to Comparative Example 1, which have no vanadium oxo anions on a surface on the nanoparticles, are respectively introduced as a material of forming an electron transport layer, wherein the surface-modified zinc-containing oxide nanoparticles of Examples 2 and 4 have wider band gap energy than those of Comparative Example 1 and simultaneously, upshifted conductive band minimum (CBM), an electroluminescent diode including such surface-modified zinc-containing oxide nanoparticles according to an embodiment in an electron transport layer exhibits much increased electron transport characteristics, whereby, much more excellent performance and life-span characteristics.

While this disclosure has been described in connection with what is presently considered to be practical embodiments, it is to be understood that the invention is not limited to the disclosed embodiments. On the contrary, it is intended to cover various modifications included within the scope of the appended claims.

## Claims

1. A zinc-containing oxide nanoparticle comprising zinc, and an additional metal other than zinc, and having an oxo anion of vanadium on a surface of the nanoparticle.

2. The zinc-containing oxide nanoparticle of claim 1, wherein the additional metal comprises an alkaline earth metal, zirconium, tungsten, titanium, yttrium, aluminum, gallium, indium, tin, cobalt, vanadium, or a combination thereof.

3. The zinc-containing oxide nanoparticle of claim 1 or 2, wherein the additional metal comprises magnesium.

4. The zinc-containing oxide nanoparticle of any preceding claim, wherein a mole ratio of zinc to the additional metal in the zinc-containing oxide nanoparticle is 99.9:0.1 to 70:30.

5. The zinc-containing oxide nanoparticle of any preceding claim, wherein the oxo anion of vanadium comprises one or more of anions represented by the chemical formulas of Group 1:
(Group 1) VO₃⁻, VO₄³⁻, V₂O₇⁴⁻, V₃O₉³⁻, V₄O₁₂⁴⁻, V₅O₁₄³⁻, V₅O₁₅⁵⁻, V₆O₁₈⁶⁻, V₁₀O₂₈⁶⁻, V₁₂O₃₂⁴⁻, V₁₃O₃₄³⁻, V₁₈O₄₂¹²⁻, VO₂(OH)⁻₂, VO₃(OH)²⁻.

6. The zinc-containing oxide nanoparticle of any preceding claim, wherein the zinc-containing oxide nanoparticle has a particle size of greater than or equal to about 1 nanometer and less than or equal to about 30 nanometers.

7. A method of preparing the zinc-containing oxide nanoparticle of any preceding claims, comprising
dissolving a compound comprising an oxo anion of vanadium in a first organic solvent in which a basic compound is dissolved to obtain a first solution,
dissolving a zinc precursor and a precursor of an additional metal other than zinc in a second organic solvent to obtain a second solution, and
combining the first solution with the second solution to react them with each other.

8. The method of claim 7, wherein the compound comprising the oxo anion of vanadium is a salt comprising the oxo anion of vanadium and an alkaline metal cation.

9. The method of claim 7 or claim 8,
wherein the basic compound comprises an organic base comprising an organic group, an inorganic base comprising an alkaline metal or an alkaline earth metal, or a combination thereof; and
wherein the first organic solvent and the second organic solvent each independently comprise a C1 to C10 alcoholic solvent, dimethyl sulfoxide, a C3 to C15 hydrocarbon solvent, or a combination thereof, and the first organic solvent and the second organic solvent are different from each other.

10. The method of any one of claims 7 to 9, wherein the combining the first solution with the second solution comprises heating and stirring the combined mixture of the first solution and the second solution.

11. The method of any one of claims 7 to 10, wherein the method further comprises, after the combining the first solution and the second solution, adding a third solvent that is not miscible with the first organic solvent and the second organic solvent to a reaction mixture of the first solution and the second solution to form a precipitate.

12. An electroluminescent diode, comprising
a first electrode and a second electrode that face each other,
a light emitting layer, comprising semiconductor nanoparticles, disposed between the first electrode and the second electrode, and
an electron transport layer between the light emitting layer and the second electrode,
wherein the electron transport layer comprises the zinc-containing oxide nanoparticles of any of claims 1 to 6.

13. The electroluminescent diode of claim 12, wherein a thickness of the electron transport layer is greater than or equal to about 5 nanometers and less than or equal to about 60 nanometers.

14. The electroluminescent diode of claim 12 or claim 13, wherein the electroluminescent diode further comprises a hole auxiliary layer between the first electrode and the light emitting layer.

15. A display device comprising the electroluminescent diode of any one of claims 12 to 14.

## Patentansprüche

1. Zinkhaltiges Oxidnanopartikel, das Zink und ein zusätzliches anderes Metall als Zink umfasst, und ein Oxoanion von Vanadium auf einer Oberfläche des Nanopartikels aufweist.

2. Zinkhaltiges Oxidnanopartikel nach Anspruch 1, wobei das zusätzliche Metall ein Erdalkalimetall, Zirkonium, Wolfram, Titan, Yttrium, Aluminium, Gallium, Indium, Zinn, Kobalt, Vanadium oder eine Kombination davon umfasst.

3. Zinkhaltiges Oxidnanopartikel nach Anspruch 1 oder 2, wobei das zusätzliche Metall Magnesium umfasst.

4. Zinkhaltiges Oxidnanopartikel nach einem vorhergehenden Anspruch, wobei ein Molverhältnis von Zink zu dem zusätzlichen Metall in dem zinkhaltigen Oxidnanopartikel 99,9:0,1 bis 70:30 ist.

5. Zinkhaltiges Oxidnanopartikel nach einem vorhergehenden Anspruch, wobei das Oxoanion von Vanadium eines oder mehrere von Anionen dargestellt durch die chemischen Formeln von Gruppe 1 umfasst:
(Gruppe 1) VO₃-, VO₄³⁻, V₂O₇⁴⁻, V₃O₉³⁻, V₄O₁₂⁴⁻, V₅O₁₄³⁻, V₅O₁₅⁵⁻, V₆O₁₈⁶⁻, V₁₀O₂₈⁶⁻, V₁₂O₃₂⁴⁻, V₁₃O₃₄³⁻, V₁₈O₄₂¹²⁻, VO₂(OH)⁻₂, VO₃(OH)²⁻.

6. Zinkhaltiges Oxidnanopartikel nach einem vorhergehenden Anspruch, wobei das zinkhaltige Oxidnanopartikel eine Partikelgröße von mehr als oder gleich etwa 1 Nanometer und weniger als oder gleich etwa 30 Nanometer aufweist.

7. Verfahren zur Herstellung des zinkhaltigen Oxidnanopartikels nach einem der vorhergehenden Ansprüche, umfassend
Auflösen einer Verbindung, die ein Oxoanion von Vanadium umfasst, in einem ersten organischen Lösungsmittel, in dem eine basische Verbindung aufgelöst ist, um eine erste Lösung zu erhalten,
Auflösen eines Zinkvorläufers und eines Vorläufers eines zusätzlichen anderen Metalls als Zink in einem zweiten organischen Lösungsmittel, um eine zweite Lösung zu erhalten, und
Kombinieren der ersten Lösung mit der zweiten Lösung, um sie miteinander zu reagieren.

8. Verfahren nach Anspruch 7, wobei die Verbindung, die das Oxoanion von Vanadium umfasst, ein Salz ist, welches das Oxoanion von Vanadium und ein Alkalimetallkation umfasst.

9. Verfahren nach Anspruch 7 oder Anspruch 8,
wobei die basische Verbindung eine organische Base, die eine organische Gruppe umfasst, eine anorganische Base, die ein Alkalimetall oder ein Erdalkalimetall umfasst, oder eine Kombination davon umfasst; und
wobei das erste organische Lösungsmittel und das zweite organische Lösungsmittel jeweils unabhängig ein alkoholisches C1- bis C10-Lösungsmittel, Dimethylsulfoxid, ein C3- bis C15-Kohlenwasserstofflösungsmittel oder eine Kombination davon umfassen und das erste organische Lösungsmittel und das zweite organische Lösungsmittel voneinander verschieden sind.

10. Verfahren nach einem der Ansprüche 7 bis 9, wobei das Kombinieren der ersten Lösung mit der zweiten Lösung Erhitzen und Rühren der kombinierten Mischung aus der ersten Lösung und der zweiten Lösung umfasst.

11. Verfahren nach einem der Ansprüche 7 bis 10, wobei das Verfahren ferner nach dem Kombinieren der ersten Lösung und der zweiten Lösung Hinzufügen eines dritten Lösungsmittels, das nicht mit dem ersten organischen Lösungsmittel und dem zweiten organischen Lösungsmittel mischbar ist, zu einer Reaktionsmischung aus der ersten Lösung und der zweiten Lösung, um ein Präzipitat zu bilden, umfasst.

12. Elektrolumineszenzdiode, umfassend
eine erste Elektrode und eine zweite Elektrode, die einander zugewandt sind,
eine lichtemittierende Schicht, die Halbleiternanopartikel umfasst, die zwischen der ersten Elektrode und der zweiten Elektrode angeordnet ist, und
eine Elektronentransportschicht zwischen der lichtemittierenden Schicht und der zweiten Elektrode,
wobei die Elektronentransportschicht die zinkhaltigen Oxidnanopartikel nach einem der Ansprüche 1 bis 6 umfasst.

13. Elektrolumineszenzdiode nach Anspruch 12, wobei eine Dicke der Elektronentransportschicht mehr als oder gleich etwa 5 Nanometer und weniger als oder gleich etwa 60 Nanometer ist.

14. Elektrolumineszenzdiode nach Anspruch 12 oder Anspruch 13, wobei die Elektrolumineszenzdiode ferner eine Lochhilfsschicht zwischen der ersten Elektrode und der lichtemittierenden Schicht umfasst.

15. Anzeigevorrichtung, umfassend die Elektrolumineszenzdiode nach einem der Ansprüche 12 bis 14.

## Revendications

1. Nanoparticule d'oxyde contenant du zinc comprenant du zinc et un métal supplémentaire autre que le zinc, et possédant un oxyanion de vanadium sur une surface de la nanoparticule.

2. Nanoparticule d'oxyde contenant du zinc de la revendication 1, ledit métal supplémentaire comprenant un métal alcalino-terreux, du zirconium, du tungstène, du titane, de l'yttrium, de l'aluminium, du gallium, de l'indium, de l'étain, du cobalt, du vanadium ou une combinaison de ceux-ci.

3. Nanoparticule d'oxyde contenant du zinc de la revendication 1 ou 2, ledit métal supplémentaire comprenant du magnésium.

4. Nanoparticule d'oxyde contenant du zinc d'une quelconque revendication précédente, un rapport molaire du zinc au métal supplémentaire dans la nanoparticule d'oxyde contenant du zinc étant de 99,9:0,1 à 70:30.

5. Nanoparticule d'oxyde contenant du zinc d'une quelconque revendication précédente, ledit oxyanion du vanadium comprenant un ou plusieurs des anions représentés par les formules chimiques du Groupe 1 :
(Groupe 1) VO₃-, VO₄³⁻, V₂O₇⁴⁻ ; V₃O₉³⁻, V₄O₁₂⁴ ; V₅O₁₄³⁻ ; V₅O₁₅⁵⁻, V₆O₁₈⁶⁻, V₁₀O₂₈⁶⁻, V₁₂O₃₂⁴⁻ ; V₁₃O₃₄³⁻ ; V₁₈O₄₂¹²⁻, VO₂(OH)⁻₂, VO₃(OH)²⁻.

6. Nanoparticule d'oxyde contenant du zinc d'une quelconque revendication précédente, ladite nanoparticule d'oxyde contenant du zinc possédant une taille de particule supérieure ou égale à environ 1 nanomètre et inférieure ou égale à environ 30 nanomètres.

7. Procédé de préparation de la nanoparticule d'oxyde contenant du zinc d'une quelconque revendication précédente, comprenant
la dissolution d'un composé comprenant un oxyanion de vanadium dans un premier solvant organique dans lequel un composé basique est dissous pour obtenir une première solution,
la dissolution d'un précurseur de zinc et d'un précurseur d'un métal supplémentaire autre que le zinc dans un deuxième solvant organique pour obtenir une seconde solution, et
la combinaison de la première solution avec la seconde solution pour les faire réagir l'une avec l'autre.

8. Procédé de la revendication 7, ledit composé comprenant l'oxyanion de vanadium étant un sel comprenant l'oxyanion de vanadium et un cation de métal alcalin.

9. Procédé de la revendication 7 ou la revendication 8,
ledit composé basique comprenant une base organique comprenant un groupe organique, une base inorganique comprenant un métal alcalin ou un métal alcalino-terreux, ou une combinaison de ceux-ci ; et
ledit premier solvant organique et ledit deuxième solvant organique comprenant chacun indépendamment un solvant alcoolique en C1 à C10, du diméthylsulfoxyde, un solvant hydrocarboné en C3 à C15, ou une combinaison de ceux-ci, et ledit premier solvant organique et ledit deuxième solvant organique étant différents l'un de l'autre.

10. Procédé de l'une quelconque des revendications 7 à 9, ladite combinaison de la première solution avec la seconde solution comprenant le chauffage et l'agitation du mélange combiné de la première solution et de la seconde solution.

11. Procédé de l'une quelconque des revendications 7 à 10, ledit procédé comprenant en outre, après la combinaison de la première solution et de la seconde solution, l'addition d'un troisième solvant qui n'est pas miscible avec le premier solvant organique et le deuxième solvant organique à un mélange réactionnel de la première solution et de la seconde solution pour former un précipité.

12. Diode électroluminescente, comprenant
une première électrode et une seconde électrode qui se font face,
une couche d'émission de lumière, comprenant des nanoparticules semi-conductrices, disposée entre la première électrode et la seconde électrode, et
une couche de transport d'électrons entre la couche d'émission de lumière et la seconde électrode,
ladite couche de transport d'électrons comprenant les nanoparticules d'oxyde contenant du zinc de l'une quelconque des revendications 1 à 6.

13. Diode électroluminescente de la revendication 12, une épaisseur de la couche de transport d'électrons étant supérieure ou égale à environ 5 nanomètres et inférieure ou égale à environ 60 nanomètres.

14. Diode électroluminescente de la revendication 12 ou la revendication 13, ladite diode électroluminescente comprenant en outre une couche auxiliaire de trous entre la première électrode et la couche d'émission de lumière.

15. Dispositif d'affichage comprenant la diode électroluminescente de l'une quelconque des revendications 12 à 14.
